# EUROPEAN PATENT SPECIFICATION

(11) **EP 3 925 011 B1**
(45) Date of publication and mention of the grant of the patent: **31.07.2024**
(21) Application number: 20703765.6
(22) Date of filing: 12.02.2020
(51) Int. Cl.: H01L 31/048, H01L 31/049

(54) **ENCAPSULATION MATERIAL**
VERKAPSELUNGSMATERIAL
MATÉRIAU D'ENCAPSULATION

(30) Priority: 13.02.2019 EP 19156919
(43) Date of publication of application: 22.12.2021
(73) Proprietor: TIGER Coatings GmbH & Co. KG, 4600 Wels (AT)
(72) Inventor: LEMESANSZKINE-PISZKOR, Nikoletta, 4702 Wallern an der Trattnach (AT); BIERINGER, Harald, 4020 Linz (AT); WIESINGER, Klaus, 4623 Gunskirchen (AT); LEITNER, Sebastian, 4040 Linz (AT); BUCHINGER, Gerhard, 4641 Steinhaus (AT)
(74) Representative: Dilg, Haeusler, Schindelmann Patentanwaltsgesellschaft mbH
(86) International application number: PCT/EP2020/053639
(87) International publication number: WO 2020/165276

(56) References cited:
- EP-A1- 3 026 076
- EP-A1- 3 416 200
- JP-A- 2013 199 604
- US-A1- 2013 281 573

## Description

### FIELD OF INVENTION

The present invention relates to the field of fiber-reinforced plastics and in particular its application as encapsulating material for photovoltaic modules.

### BACKGROUND

Conventional photovoltaic panels, as widely known and spread on the market, typically employ glass, metal and polymer foils, such as EVA foils, as encapsulating material for the photovoltaic modules. These materials are suitable to protect the encapsulated photovoltaic modules against environmental influences, such as weathering, moisture and hail to guarantee the desired lifetime of the entire system. Such solar panels are for instance described in Thomas Dittrich (Helmholtz Center Berlin for Materials and Energy, Germany): Materials Concepts for Solar Cells, 2nd Edition, April 2018; Xiaodong Wang, Zhiming M. Wang (Physics, Materials, and Devices): High-Efficiency Solar Cells, November 2013; Soteris Kalogirou (Fundamentals and Applications): McEvoy's Handbook of Photovoltaics 3rd Edition, September 2017; Angèle Reinders, Pierre Verlinden, Wilfried van Sark, Alexandre Freundlich: Photovoltaic Solar Energy: From Fundamentals to Applications, Februar 2017; Gavin Conibeer, Arthur Willoughby: Solar cell materials: developing technologies, 2014.

EP 2863443 B1 discloses fiber reinforced plastics as alternative encapsulating material for PV modules and discloses a photovoltaic panel, comprising at least one solar cell, which is covered with transparent composite material at least on its side directed towards the light and its opposite side directed away from the light with transparent composite material being a plastic based on an acrylate that contains epoxy groups and reinforced with glass fibers.

CN106299000A discloses an encapsulating material for photovoltaic modules comprising 30-50 parts by weight of fiber cloth being obtained by weaving fiber materials and 50-70 parts by weight of acrylic powder coating material, comprising acrylic resin, a curing agent and an additive, wherein the acrylic powder coating material is coated uniformly on the fiber cloth. Further, a method of preparing said encapsulating material for PV modules is disclosed.

CN106283677A discloses an encapsulating material for photovoltaic modules comprising 30-50 parts by weight of fiber cloth being obtained by weaving a fiber material and 50-70 parts by weight of super weather resistant polyester powder coating material, comprising super weather resistant polyester resin and a curing agent, wherein the super weather resistant polyester powder coating material is coated uniformly on the fiber cloth. Further, a method of preparing said encapsulating material for PV modules is disclosed.

EP 3 416 200 A1 relates to a packaging material for a photovoltaic module and a method for preparing a packaging material.

JP 2013 199604 A relates to a curable coating composition, a laminated polyester resin film and solar cell backsheet.

EP 3 026 076 A1 relates to a vinyl ester powder pre-preg.

US 2013/0281573 A1 relates to an epoxy resin composition for fiber-reinforced composite materials, pre-preg, and fiber-reinforced composite material.

Further information is given in the following patent applications: CN108133973A, CN10801018723A, CN108022989A, WO2018076525A21, WO2018076524A1, WO2017140002A1.

### SUMMARY

The technical requirements of the encapsulation material are not limited to long-term protection of the modules itself. Properties such as electrical insulation, weathering resistance, UV-stability, resistance against chemicals, transparency, ease of production, ecological friendliness, flexibility, economic efficiency, coloration and lightweight are highly desirable properties for encapsulating materials. While certain of these properties, such as weathering resistance and transparency can be achieved with conventional encapsulation, other properties, in particular flexibility, lightweight and coloration in combination with long-term stability cannot be realized by conventional PV panels.

Encapsulation materials (also referred to as housing materials), which are based on acrylic resin based powder coating materials and the resulting fiber reinforced plastics offer on the one hand excellent weathering stability and UV-resistance but on the other hand the high price, poor mechanical properties and the incompatibility with other powder coating materials, resulting in the requirement of strict separation during production and application, limits their application. Furthermore, decent coloration of acrylic powder coatings compositions is difficult to achieve.

Encapsulation materials, which are based on polyester powder coatings and the resulting fiber reinforced plastics materials offer good to excellent UV stability, however, typically high curing temperatures are required resulting in an increased energy demand during the production of the photovoltaic panels. In addition, polyester based powder coating systems generally display high melt/softening viscosities, which renders the preparation of the encapsulating materials difficult. As a consequence of the high viscosities of the polyester powder coating material, insufficient impregnation of the fiber cloth can occur.

In view of the above-described situation, there still exists a need for an improved technique that enables to provide an encapsulation material with improved characteristics.

This need may be met by the subject matter according to the independent claims. Advantageous embodiments of the herein disclosed subject matter are described by the dependent claims.

The claimed invention is defined by the independent claims. Features which are not included as mandatory features in an independent claim are hence optional features of the subject matter defined by the independent claim.

According to a first aspect of the herein disclosed subject matter there is provided a housing material for a photovoltaic module.

According to embodiments of the first aspect there is provided a housing material for a photovoltaic module comprising a plurality of fibers and powder coating material, wherein the powder coating material comprises an epoxy resin with an epoxy equivalent weight in between 150 g/eq. and 1800 g/eq; and wherein a glass transition temperature of the (uncured) powder coating material is at least 30 °C (°C = degrees Celsius), in particular at least 40 °C, further in particular at least 45 °C, and further in particular at least 50 °C, measured with Differential Scanning Calorimetry at a heating rate of 20 K / min (K / min = Kelvin per minute).

According to a second aspect of the herein disclosed subject matter there is provided a photovoltaic module.

According to embodiments of the second aspect, the photovoltaic module comprises a housing material according to the first aspect or an embodiment thereof.

According to a third aspect of the herein disclosed subject matter, there is provided a use of a powder coating material for manufacturing a fiber reinforced housing material for a photovoltaic cell.

According to embodiments of the third aspect there is provided a use of a powder coating material for manufacturing a fiber reinforced housing material for a photovoltaic cell, wherein the powder coating material comprises an epoxy resin with an epoxy equivalent weight in between 150 g/eq. and 1800 g/eq; and wherein a glass transition temperature of the (uncured) powder coating material is at least 30 °C measured with Differential Scanning Calorimetry at a heating rate of 20 K / min.

According to a fourth aspect of the herein disclosed subject matter, a method of manufacturing a photovoltaic module not being part of the invention is provided.

According to embodiments of the fourth aspect there is provided a method of manufacturing a photovoltaic module, the method comprising: providing a plurality of fibers; impregnating the plurality of fibers with a powder coating material; wherein the powder coating material comprises an epoxy resin with an epoxy equivalent weight in between 150 g/eq. and 1800 g/eq; and wherein a glass transition temperature of the (uncured) epoxy resin is at least 30 °C measured with Differential Scanning Calorimetry at a heating rate of 20 K / min.

According to a fifth aspect of the herein disclosed subject matter a powder coating material is provided.

According to embodiments of the fifth aspect there is provided a powder coating material for impregnating a plurality of fibers, the powder coating material comprising: an epoxy resin with an epoxy equivalent weight in between 150 g/eq. and 1800 g/eq; wherein a glass transition temperature of the (uncured) powder coating material is at least 30 °C, in particular at least 40 °C, and further in particular at least 50 °C, measured with Differential Scanning Calorimetry at a heating rate of 20 K / min.

### DESCRIPTION OF EXEMPLARY EMBODIMENTS

In the following, exemplary embodiments of the herein disclosed subject matter are described, any number and any combination of which may be realized in an implementation of aspects of the herein disclosed subject matter.

It is further noted that any percentage provided herein shall be considered a weight percentage and shall be considered as being based on the overall (entire) powder coating material (i.e. on weight of the overall powder coating material) where applicable and where not explicitly indicated otherwise. In this regard, terms like "with respect to", "based on", "with regard to" are considered synonymous herein. Weight percent is in some cases abbreviated by "wt%" (weight percent (or weight %). Further abbreviations used herein are: micrometer = µm; millimeter = mm; hour = h; minute = min; second = s; Kelvin = K; degrees Celcius = °C; ultraviolet radiation = UV or UV radiation.

It is further noted that "epoxy resin which was modified with Novolac", "Novolac modified epoxy resin", "Novolak based epoxy resin" and "Novolak epoxy resin" are considered synonymous herein. Furthermore, the terms like "Novolac" and "Novolak" are considered synonymous herein.

It is further noted that according to an embodiment the term "does not comprise/contain/include" includes the meaning "is free from".

It is further noted that herein a reference to a glass transition temperature Tg shall be considered as reference to the glass transition temperature of the uncured material if not otherwise stated. According to an embodiment, the glass transition temperature (Tg) of a material is determined by differential scanning calorimetry (DSC) measurements with a heating and cooling rate of 20 K/min. According to a further embodiment, the materials are first heated from 25 °C to 80 °C, the temperature is hold for 1 minute, cooled to 20°C (20 K/min) and the temperature is hold for 1 minute again. In a second step the material is heated to 130°C which is used for determination of the Tg (20 K/min). The Tg is determined by evaluating the point of onset of the endothermal step.

According to an embodiment, the glass transition temperature is measured according to ISO 11357-2 (NETZSCH, DSC 204 F1 Phoenix).

In the context of the present technology, the term "about" in combination with a numerical value means in particular within a range of plus and minus 10 % with respect to the given value. For instance, "about 6 µm" means preferably within a range of 5.4 µm to 6.6 µm.

Further, it is noted that herein any overlapping ranges specified for the same quantity in some embodiments (e.g. for Tg: range 1 = between 40°C and 60 °C and range 2 = between 50 °C and 70 °C) shall define inter alia also any partial range or combined range derivable from the specified boundaries (i.e. in the given example "between 40 °C and 60 °C", "between 40 °C and 50 °C", "between 40 °C and 70 °C", "between 50 °C and 60 °C", "between 50°C and 70 °C", "between 60 °C and 70 °C", etc.). This applies for overlapping closed ranges (as given in the examples), overlapping open ranges (e.g. at least 50 °C, at least 60 °C, thus including also a range between 50 °C and 60 °C) as well as for one or more open range overlapping with one or more closed range.

In the context of the present technology, the term "hydroxyl number" or hydroxyl value (HV) is the value which is preferably defined as the number of milligrams (mg) of potassium hydroxide required to neutralize the acetic acid taken up on acetylation of one gram of a chemical substance that contains free hydroxyl groups. The hydroxyl value is a measure of the content of free hydroxyl groups in a chemical substance, usually expressed in units of the mass of potassium hydroxide (KOH) in milligrams equivalent to the hydroxyl content of one gram of the chemical substance. According to an embodiment, the analytical method used to determine hydroxyl value preferably involves acetylation of the free hydroxyl groups of the substance in organic solvent. After completion of the reaction, water is added, and the remaining unreacted acetylation reagent, which is preferably acetic anhydride, is hydrolyzed and measured by titration with potassium hydroxide.

According to a further embodiment, the hydroxyl value (HV) is determined according to ÖNORM EN ISO 4629.

In the context of the present technology, the term "acid number" or acid value (AV) is preferably defined as the mass of potassium hydroxide (KOH) in milligrams that is required to neutralize one gram of chemical substance. The acid number is a measure of the amount of carboxylic acid groups in a chemical compound, such as a fatty acid, or in a mixture of compounds. According to an embodiment, a known amount of sample dissolved in organic solvent is titrated with a solution of potassium hydroxide (KOH) with known concentration and with phenolphthalein as a color indicator.

According to a further embodiment, the acid value (AV) is determined analogously to ÖNORM EN ISO 2114 with the difference that a mixture of 28 parts of acetone and 1 part of pyridine (% w/w) is used as a solvent. As a solvent for the partial acid value, a mixture of 2 parts of pyridine and 1 part of methanol is used.

According to an embodiment, a housing material for a photovoltaic module comprises a plurality of fibers and powder coating material, wherein the powder coating material comprises an epoxy resin with an epoxy equivalent weight in between 150 g/eq. and 1800 g/eq and wherein a glass transition temperature of the powder coating material is at least 30 °C measured with Differential Scanning Calorimetry at a heating rate of 20 K / min.

Accordingly, a method of manufacturing a photovoltaic module comprises providing a plurality of fibers; and impregnating the plurality of fibers with a powder coating material; wherein the powder coating material comprises an epoxy resin with an epoxy equivalent weight in between 150 g/eq. and 1800 g/eq; and wherein a glass transition temperature of the epoxy resin is at least 30 °C measured with Differential Scanning Calorimetry at a heating rate of 20 K / min.

According to an embodiment, the plurality of fibers form a fiber cloth.

Accordingly, a use of a powder coating material for manufacturing a fiber reinforced housing material for a photovoltaic cell comprises using a powder coating material which comprises an epoxy resin with an epoxy equivalent weight in between 150 g/eq. and 1800 g/eq and which exhibits a glass transition temperature of at least 30 °C measured with Differential Scanning Calorimetry at a heating rate of 20 K / min.

Accordingly, powder coating material for impregnating a plurality of fibers comprises: an epoxy resin with an epoxy equivalent weight in between 150 g/eq. and 1800 g/eq; wherein a glass transition temperature of the powder coating material is at least 30 °C measured with Differential Scanning Calorimetry at a heating rate of 20 K / min.

Generally herein, if not specified otherwise, a glass transition temperature is measured with Differential Scanning Calorimetry at a heating rate of 20 K / min. According to an embodiment, the glass transition temperature of the powder coating material is at least at least 30 °C, in particular at least 40 °C or, in another embodiment at least 50 °C. According to a further embodiment, the glass transition temperature is taken from the specification of the manufacturer.

A powder coating material as used herein is a coating material that is suitable for application in powder form, i.e. as a plurality of particles which can be applied by a spray gun, by a needle roller, by rippling or by non-impact printing (e.g. laser printing) or by any other suitable method. Non-impact printing of the powder coating material can be performed as described in any of WO 2018/167015, WO2018/166998, WO2018/167012, WO2018167000, WO2018/167020, WO2018/167004, WO2018/167007 and WO2018/167009.

According to an embodiment, generally herein any component, e.g. of the housing material, may comprise a single type of the component or a mixture of at least two types of the component. For example, the epoxy resin may consist of a single type of expoy resin of may comprise or consist of two or more types of epoxy resin.

### Epoxy

According to an embodiment, the epoxy equivalent weight (EEW) of the epoxy resin is in between 150 g/eq. and 1800 g/eq, in particular between 200 g/eq. and 800 g/eq, e.g. between 400 g/eq and 700 g/eq or, in a further embodiment, between 450 g/eq and 650 g/eq. The information on the EEW (and, in respective embodiments also the information on the glass transition temperature, the melting point and/or the softening point) is typically provided by the manufacturer of the epoxy resin.

According to a further embodiment, the epoxy equivalent weight (EEW) is defined as the mass of a compound or a mixture of compounds that contains one (1) mol of epoxy groups. A high EEW means a low content of epoxy group within the sample. The EEW is usually provided by the manufacturer of the epoxy resins.

According to a further embodiment, a glass transition temperature of the epoxy resin is above 30°C, in particular above 40 °C, and further in particular above 50°C.

According to an embodiment, the epoxy resin is selected from bisphenol epoxy resin, polyphenol epoxy resin, novolak epoxy resin, phenolic epoxy resin, hydrogenated bisphenol epoxy resin, hydrogenated polyphenol epoxy resin, halogenated bisphenol epoxy resin, halogenated polyphenol epoxy resin, aliphatic epoxy resin e.g. cycloaliphatic epoxy resin, and mixtures thereof. These epoxy resins may provide a high resistance against chemicals and a high hydrolysis resistance. This may protect the photovoltaic module from penetrating moisture and may provide a long endurance humid environment. Further, these epoxy resins provide good mechanical properties, in particular good flexibility, corrosions resistance, as well as good adhesive properties. The good adhesive properties may assist the lamination process of a plurality of layers and may provide a good inter-layer adherence. Further, these epoxy resins provide excellent electrical insulation properties in a wide temperature range, as well as good temperature resistance. Furthermore, these epoxy resins may be suitable to achieve the specifications of the powder coating materials as described herein. The bisphenol epoxy resin, hydrogenated bisphenol epoxy resin and halogenated bisphenol epoxy resin preferably have an polyether backbone.

According to an embodiment, the epoxy resin accounts for at least 1 wt% of the total weight of the powder coating material. According to a further embodiment, the epoxy resin accounts for at least 10 wt%, in particular at least 20 wt%, in particular at least 30 wt%, in particular at least 50 wt% and even further in particular at least 60 wt% of the total weight of the powder coating material.

According to an embodiment, the epoxy resin accounts for more than 25 wt% of the total weight of the powder coating material.

According to a further embodiment, the epoxy resin accounts for at least 28 wt%, in particular at least 30 wt%, in particular at least 33 wt%, in particular at least 35 wt% and even further in particular at least 40 wt% of the total weight of the powder coating material.

According to an embodiment, the epoxy resin is a solid epoxy resin.

According to an embodiment, the epoxy resins is a thermosetting resin.

According to an embodiment, the epoxy resin has a weight average molecular weight Mw in between 700 Da and 30000 Da, in particular between 1000 Da and 15000 Da, further in particular between 1500 Da and 10000 Da and even further in particular between 2000 Da and 5000 Da (1 Da = 1 g/mol).

According to an embodiment, the epoxy resin has a polyether backbone, wherein a resin with a polyether backbone is defined as having at least two ether functional groups within the polymeric backbone.

According to a further embodiment the epoxy resin comprises a Novolac modified epoxy resin.

According to a further embodiment the Novolac modified epoxy resins are epoxy resins typically manufactured from novolac resin and epichlorohydrin.

According to an embodiment, epoxy resins, having a polyether backbone, show particularly advantageous properties as good mechanical properties, in particularly good flexibility, corrosions resistance, as well as good adhesive properties. The good adhesive properties may assist the lamination process of a plurality of layers and may provide a good inter-layer adherence. Further, epoxy resins, having a polymer backbone, provide excellent electrical insulating properties in a wide temperature range, as well as good temperature resistance. Furthermore, these epoxy resins, having a polyether backbone, may be suitable to achieve the specifications of the powder coating materials as described herein

According to a further embodiment, the Novolac modified epoxy resins show particularly advantageous properties as good mechanical properties, in particularly good flexibility, corrosions resistance, as well as good adhesive properties. The good adhesive properties may assist the lamination process of a plurality of layers and may provide a good inter-layer adherence. Further the Novolac modified epoxy resins provide excellent electrical insulating properties in a wide temperature range, as well as good temperature resistance. Furthermore, these Novolac modified epoxy resins may be suitable to achieve the specifications of the powder coating materials as described herein

According to an embodiment the epoxy resin does not comprise any acrylic monomers and/ or an acrylic polymeric backbone.

According to a further embodiment the epoxy resin is free of acrylic resin.

According to a further embodiment the epoxy resin is essentially free of acrylic resin.

According to a further embodiment the epoxy resin is free of hydrogenated epoxy resin.

According to a further embodiment, the softening temperature (softening point) of the epoxy resin lies between 60 °C and 160°C, e.g. between 70 °C and 130°C and even more preferably between 70 °C and 110°C and particularly preferable between 70 °C and 100 °C (e.g. according to supplier specifications or as defined herein - see definition of softening point and viscosity).

Exemplary, epoxy resin as disclosed in WO 2001/092367 may be employed.

According to a further embodiment the epoxy resin is the reaction product of Bisphenol A (4-[2-(4-Hydroxyphenyl)propane-2-yl]phenol, BPA) and/or Bisphenol F (4,4'-methylenebisphenol, BPF) and epichlorohydrin. The bisphenol based epoxy resin may be at least partially or even fully hydrogenated. Exemplary, the epoxy resin may be based on the addition product of hydrogenated BPA (4,4'-lsopropylidenedicyclohexanol) and epichlorohydrin. Other epoxy resins, which are based on bisphenol compounds and their at least partially hydrogenated derivatives as known in the art are also within the scope of the herein disclosed subject matter. The bisphenol based epoxy resin preferably has a polyether backbone.

According to another embodiment novolak epoxy resins, which may be the reaction products of novolak and epichlorohydrin may be used. Novolak resins may be generated by the reaction of phenolic compounds and formaldehyde. Exemplary phenolic compounds that may be used for the synthesis of novolak are phenol, cresole, xylenole, resorcine, naphtole and mixtures thereof. Novolak based on other phenolic compounds are also within the scope of the herein disclosed subject matter. The use of novolak based epoxy resins may increase the crosslinking density and therefore may also increase the chemical stability of the housing material.

According to an embodiment, the epoxy resin may also consist of a mixture of at least two epoxy resins. In such cases, the epoxy equivalent weight (EEW) of the epoxy resin is determined as the arithmetic mean of the EEWs of the epoxy resins. Exemplary, the EEW of an epoxy resin consisting of a 3:1 mixture (by weight) of epoxy resin A with an EEW of 400 g/eq and epoxy resin B with an EEW of 600g/eq may be calculated as follows: (0.75*EEW (A) + 0.25*EEW(B)= (0.75*400 g/eq + 0.25*600 g/eq) = 450 g/eq.

Exemplary, commercially available epoxy resins are listed in the following: D.E.R. epoxy resins supplied by Dow Chemical/Olin (e.g.: D.E.R. 662E, D.E.R. 671), Araldite epoxy resin supplied by Huntsman Advanced Materials (e.g.: Araldite GT6248, Araldite GT 7071, Araldite GT 7072, Araldite GT 6071) Eposir epoxy resins supplied by Sir Industriale (e.g.: Eposir 7161, Eposir 7165, Eposir 7167 PG), Kukdo epoxy resins supplied by Kukdo Chemical (e.g.: YD-012, KD-211E, KD-21 1G, KD-242GHF, EPOXY ST- 5080, Epoxy ST 4100 D).

As commercially available novolak modified epoxy resins may for example be used: Araldite GT 7220 (Huntsman), AralditeGT 6259 (Huntsman), D.E.R. 642U (Dow), KD-211D (Kukdo) oder KD-211H (Kukdo). Commercial examples for Novolak epoxy resins are Araldite ECN 1299, Araldite GY280, D.E.N. 438, D.E.N. 439, Quatrex 1010.

According to an embodiment, the epoxy resin is a mixture of at least two different epoxy resins.

The examples listed above and provided herein should in no way be regarded as a mandatory limitation. Any suitable epoxy resin according to the given specifications are within the scope of the herein disclosed subject matter.

### Polyester

According to an embodiment, the powder coating material further comprises a polyester resin, in particular wherein a glass transition temperature of the polyester resin is least 30 °C. According to a further embodiment, the glass transition temperature of the polyester resin is at least 40 °C and further in particular at least 50 °C. According to a further embodiment, the polyester resin is amorphous or at least partially amorphous.

According to a further embodiment, the weight average molecular weight (Mw) of the polyester resin is in a range between 1000 and 30000 Da, in particular between 2000 and 25000 Da, further in particular between 3000 and 20000 Dalton and even further in particular between 4000 and 15000 Da and further in particular between 5000 and 12000 Da.

According to an embodiment, the polyester resin comprises hydroxyl groups and/or carboxyl groups. According to a further embodiment, a hydroxyl value of the polyester resin is between 10 mg KOH/g and 300 mg KOH/g and/or the carboxyl value of the polyester resin is between 5 mg KOH/g and 100 mg KOH/g.

Herein, the terms "polyester" and "polyester resin" are used synonymously. Polyester resins comprising functional groups may provide crosslinking with other components (curing agents, epoxy resins, etc.), in particular with the epoxy resin. Polyester resins may increase the chemical stability, hydrolytic stability, weathering resistance, etc. of the housing material.

According to an embodiment, the powder coating material comprises a polyester resin, wherein a glass transition temperature of the polyester resin is least 30 °C, in particular at least 40 °C and further in particular at least 50 °C and wherein the polyester resin preferably comprises an amorphous resin portion.

According to an embodiment, the polyester resin is amorphous. According to a further embodiment, the polyester resin is a solid polyester resin.

According to an embodiment, the softening temperature of the polyester resin lies between 60 °C and 160 °C, preferably between 70 °C and 150 °C and even more preferably between 70 °C and 130 °C (e.g. according to supplier specifications).

According to an embodiment, the powder coating material comprises more than one polyester resin, e.g.: two or three polyester resins. In cases, where more than one polyester resin is used, the hydroxyl value (HV) and/or the acid value (AV) of the polyester resin are calculated as the arithmetic mean of the individual polyesters.

According to another embodiment, the polyesters resin comprises hydroxyl groups (OH) and/or carboxyl groups (COOH). Consequently, alcohol functional polyesters, acid functional polyesters as wells as bifunctional polyesters are within the scope of the herein disclosed subject matter. Acid functional polyesters are presently preferred.

According to an embodiment, a bifunctional polyester resin is defined as having both an HV and an AV of at least 10 mg KOH/g, in particular at least 15mg KOH/g.

According to a further embodiment the hydroxyl value (HV) of the polyester resin is between 10 mg KOH/g and 300 mg KOH/g, in particular between 15 mg KOH/g and 200 mg KOH/g, further in particular between 20 mg KOH/g and 100 mg KOH/g, and/or the acid value (AV) of the polyester resin is between 5 mg KOH/g and 100 mg KOH/g, in particular between 15 mg KOH/g and 80 mg KOH/g and further in particular between 20 mg KOH/g and 60 mg KOH/g.

In cases, where more than one polyester resin is present in the composition, according to an embodiment the arithmetic mean of the HV and/or AV lies within the given ranges. In other words, in order to comply with the specification of the respective embodiment the HV and/or the AV of one polyester resin may also be outside the specified ranges as long as the arithmetic mean of the HV and/or AV of all polyester resins lies within the specified ranges. For example, the HV of a 1:1 mixture (by weight) of polyester resins, wherein the HV of polyester resin (A) is 9 mg KOH/g and the HV of polyester resin (B) is 200 mg KOH/g, is calculated as follows: 0.5*(OH-value(A)) + 0.5*(OH-value(B)) = 0.5*9 + 0.5*200 = 104.5 mg KOH/g.

According to an embodiment, the functional groups of the polyester resin are capable of reacting with at least one other component of the powder coating material, in particular with the epoxy resin and/or the curing agent(s) (if present).

According to an embodiment, the polyester resin accounts for 1 wt% to 80 wt% of the total weight of the powder coating material. In particular, according to an embodiment, the polyester resin accounts for 3 wt% to 60 wt%, in particular 5 wt% to 50 wt% and even further in particular 7 w% to 40 wt% of the total weight of the powder coating material.

According to another embodiment, the powder coating material is a so-called polyester epoxy hybrid powder coating material, or in short terms, hybrid powder coating material. Within the scope of the herein disclosed subject matter, the terms "polyester epoxy hybrid powder coating material" and "hybrid powder coating material" are used synonymously.

According to another embodiment, the hybrid powder coating material comprises epoxy resin and polyester resin in a weight ratio between 20:80 and 80:20, in particular between 25:75 and 75:25, in particular between 30:70 and 70:30, in particular between 35:65 and 65:35, further in particular between 40:60 and 60:40 and even further in particular between 45:55 and 55:45, e.g.: 33:66 or 52:48. Of course, a 50:50 weight ratio of polyester resin and epoxy resin is also possible. The combination of COOH functional polyester resin and epoxy resin is presently preferred for hybrid powder coating materials.

According to another embodiment, the hybrid powder coating material does not comprise any additional curing agents. In other words, the functional groups of the polyester resin are capable of reacting with the functional groups of the epoxy resin, in particular with epoxy groups of the epoxy resin.

According to another embodiment, the hybrid powder coating material does comprise additional curing agents, e.g.: isocyanates or derivatives thereof such as blocked isocyantes, uretdiones and latent isocyantes or hydroxylalkylamids, (known as PRIMID), amines, anhydrides, melamin resins, polycarboxylic acids or in other words compounds comprising at least two carboxylic acid functional groups, TGIC, glycidylesters, phenolics resins, silicon compounds and derivatives of the named curing agents. Of course other curing agents as known by a person skilled in the art, capable of reacting with the functional groups of the epoxy resin and/or the polyester resin are also within the scope of the herein disclosed subject matter.

Various commercially available polyester resins may be used as they are widely known in the art of powder coating materials. Examples for suitable commercially available polyester are: Albester 5651 (Albester 5651), Crylcoat 1544-4 (Allnex), Crylcoat 1606-1 (Allnex), Setapoll LRP 615.22 (Allnex), Crylcoat 8079-0 (Allnex), Uralac P 833 (DSM), Uralac P 800 (DSM), Uralac P 3701 (DSM), Sirales PE 7816 (SIR Industriale), Sirales PE 8210 (SIR Industriale), Crylcoat 4642-3 (Allnex), Crylcoat 4659-0 (Allnex).

According to another embodiment, the powder coating material does not contain any polyester resin.

According to an embodiment, the weight average molecular weight (Mw) of (semi)-crystalline polymeric binder materials is determined by gel permeation chromatography. As an eluent, chloroform was used at a flow rate of 1 ml/min. Calibration of the separation columns (three columns of 8 mm x 300 mm each, PSS SDV, 5 µm, 100, 1000 and 100000 A) was done by narrowly distributed polystyrene standards, and detection via refractive index detector.

According to an embodiment, the weight average molecular weight (Mw) of amorphous polymeric binder materials is determined by gel permeation chromatography. As an eluent, tetrahydrofurane was used at a flow rate of 1ml/min. Calibration of the separation columns (two columns 8 mm × 300 mm each, PSS SDV, 5µm, 1000 and 100000 A) was done by narrowly distributed polystyrene standards, and detection via refractive index detector.

### Viscosity decreasing component

Generally herein the term "viscosity" (sometimes abbreviated as "visc.") relates to the dynamic viscosity η with the unit Pascal seconds (Pas) and not to the kinematic viscosity unless specifically defined differently.

According to an embodiment, the powder coating material comprises up to 50 wt%, in particular up to 30 wt% further in particular up to 15 wt% and further in particular up to 10 wt% of a viscosity-decreasing component with respect to the total weight of the powder coating material. By adding the viscosity decreasing component the viscosity of the powder coating material may be decreased. By adding the viscosity decreasing component also the minimum viscosity of the powder coating material may be decreased. In this way the impregnation of the plurality of fibers with the powder coating material can be improved. According to an embodiment, the powder coating material comprises a (semi)crystalline binder component and wherein the (semi)crystalline binder component comprises epoxy and/or polyester resin.

According to an embodiment, the viscosity decreasing component may be selected from a (semi)crystalline binder component (i.e. an at least partially crystalline binder component (or fully crystalline binder component)), an oil, in particular castor oil or a derivative thereof, polyethylene (PE), in particular linear low density (LLD) PE, polytetrahydorfurane (poly-THF), thermoplastic elastomers, in particular, thermoplastic polyurethane (TPU), polypropylene, in particular atactic polypropylene and mixtures and/or derivatives of the previously named compounds. According to a further embodiment, the (semi)-crystalline binder component comprises epoxy resin and/or polyester resin. According to an embodiment, the viscosity decreasing component is an acrylic oligomer or polymer, in particular an acrylic flow agent.

According to an embodiment, the viscosity of a viscosity decreasing component, in particular the viscosity of an uncured (semi)crystalline component is, at 125 °C, below 10 Pas (Pas = Pascal seconds), in particular below 5 Pas, further in particular below 3 Pas and further in particular below 2 Pas. According to an embodiment, the viscosity of a viscosity decreasing component, in particular of an uncured (semi)crystalline component is at 125 °C between 0.1 Pas and 2 Pas, in particular between 0.3 Pas and 1.7 Pas and even further in particular between 0.5 and 1.5 Pas, e.g. 1.3 Pas at 125 °C.

According to an embodiment, the viscosity of a viscosity decreasing component, in particular of an uncured (semi)crystalline component is between 1.3 Pas and 1.7 Pas at 125 °C, e.g. 1.5 Pas at 125 °C. In accordance with an embodiment, the viscosity of the (semi)crystalline component is the viscosity of the pure component. A viscosity decreasing component with a viscosity as specified above may significantly improve the impregnation performance of a powder coating material.

According to an embodiment, the viscosity of the uncured viscosity decreasing component, in particular the viscosity of a (semi)crystalline component is, at 200 °C below 5 Pas, in particular below 4 Pas and even further in particular below 3.5 Pas.

For example, according to an embodiment the viscosity decreasing component is Sirales ^{®} PE 6215/F supplied by Sir Industriale SpA which has a viscosity of 1200 mPas to 3200 mPas (mPas = Milli-Pascals seconds) at 200°C. According to a further embodiment, the viscosity decreasing component is Sirales ^{®} PE 5900 supplied by Sir Industriale SpA which has a viscosity of 1500 mPas at 125°C.

According to an embodiment, the (semi)crystalline binder component displays a minimum melting enthalpy, as determined by DSC with a heating rate of 20 K/min, of greater or equal to 20 J/g, preferably 30 J/g and even more preferably 40 J/g. Within the context of the herein disclosed subject matter, the term "(semi)crystalline binder component" includes the term "crystalline binder component" or "fully crystalline binder component" as well as the term "semicrystalline binder component".

Within the scope of the herein disclosed subject matter, both the melting points and the melting enthalpy of (semi)crystalline binder components are determined by DSC measurement based on ISO 11357-3. The measurement is done at a heating rate of 20 K/min. The values stated herein for melting point and melting enthalpy refer to the Peak Melting Temperature and the Enthalpy of Melting stated in the standard.

According to an embodiment, the (semi)crystalline binder component is a (semi)crystalline resin, preferably a (semi)crystalline epoxy or polyester resin or a mixture thereof.

According to another embodiment the (semi)crystalline component may have functional groups capable of reacting with the epoxy resin and/or with curing agents and/or additional compounds of the composition, e.g. polyester resin (if present). However, non-functional (semi)crystalline binder components are also within the scope of the herein disclosed subject matter. The functional groups may for example be alcohols (OH), organic acids (COOH) and epoxides. In a preferred embodiment of the invention, (semi)crystalline OH and/or COOH functional polyester resin is used. Preferably the hydroxyl value (HV) of (semi)crystalline hydroxyl functional polyesters lies between 20 and 200 mgKOH/g, more preferably between 25 and 150 mgKOH/g and even more preferably between 30 and 100 mgKOH/g, e.g.: 35-50 mgKOH/g. Preferably, the acid value (AV) of acid functional (semi)crystalline polyester lies in between 10 and 100 mgKOH/g, preferably between 15 and 60 mgKOH/g and even more preferably between 20 and 50 mgKOH/g, eg.:28-36 mgKOH/g. According to another embodiment, the (semi)crystalline binder component is or comprises a bifunctional polyester resin.

According to another embodiment, the melting point (Mp) of the (semi)crystalline binder component is between 50 °C and 160 °C, in particular between 70 °C and 150 °C, further in particular between 80 and 140°C and even further in particular between 90 and 130°C, and may be e.g. 50, 60, 70, 80, 90, 100, 110, 120, 130, 140, 150 or 160 °C.

According to an embodiment, the viscosity of the (semi)crystalline binder component at 125 °C is below 10 Pas, preferably below 5 Pas, more preferably below 3 Pas and even more preferably below 2 Pas. For example, the viscosity may lie in between 0.1 and 8 Pas, preferably between 0.1 and 4 Pas and even more preferably between 0.1 and 2 Pas at 125 °C. According to an embodiment, the viscosity of the (semi)crystalline binder component is between 1.3 Pas and 1.7 Pas at 125 °C, e.g. 1.5 Pas at 125 °C.

According to an embodiment, the viscosity of the (semi)crystalline binder component is measured by using the cone & plate method (Brookfield CAP 2000+). Rotational speed of 700 rpm is applied for 115 seconds and an appropriate spindle is used according to the specifications of the manufacturer.

According to an embodiment, the viscosity is measured according to ISO 6721-1-11 (Rheometer, TA Instruments, AR 2000 EX).

According to another embodiment, the viscosity of the viscosity decreasing component is stated according to supplier specifications.

Exemplary, commercially available viscosity decreasing components are listed in the following: CAPA 6506, CAPA 6800 (Perstop), PolyTHF 1800 and PolyTHF 1800 (BASF), Sirales PE 5900 Crystalline polyester resin (SIR Industriale), Crylcoat 8079-0 Crystalline polyester resin (Allnex), CAPA 2803 (Perstorp), Placel 240 (Diacel) YSLV-80Xy, YSLV-120-TE, YDC-1500 Crystalline Epoxy resin (Kukdo chemical) LUVOTIX R400 (Lehmann&Voss&Co), Oxymelt A-7 (WORLÉE), CRAYVALLAC PC (ARKEMA COATING RESINS), MOWITAL B 60 H (Kuraray Europe)

### Curing agent/catalyst/additives

According to an embodiment, the powder coating material further comprises at least one curing agent. According to a further embodiment, the at least one curing agent has a softening point at a temperature of 160 °C or below, e.g. at a temperature of 150 °C or below. As is known in the art and as used herein, the softening point of a material is characterized by a value for the logarithm to the basis of 10 for the viscosity η in Pascal seconds (Pa·s) of 6.6 (log10 η/Pa·s = 6.6) (see e.g. https://web.mst.edu/~brow/PDF_viscosity.pdf). Alternatively the manufacturer specification may be used.

According to a further embodiment, the at least one curing agent is selected from the group of isocyanate, blocked isocyanate, latent iscocyanate, uretdion, amines, epoxides, carboxylic acids and anhydrides, hydroxylalkylamids (so called PRIMIDs), TGIC, glycidyl acrylates, and mixtures of two or more of these components. Of course, other curing agents as known by a person skilled in the art that are suitable for the powder coating materials as described herein are also within the scope of this application. Exemplary, commercially available curing agents are listed in the following: Vestagon B 1400 (Evonik), Vestagon B 1530 (Evonik), Vestagon B 1540 (Evonik), Vestagon EP BF 9030 (Evonik), Crelan NI 2 (Covestro), Crelan UI (Covestro), Crelan NW 5 (Covestro), Primid XL-552 (EMS), Primid QM 1260 (EMS), Aradur 3082 (Huntsman), Aradur 3088 (Huntsman), Aradur 3261 (Huntsman), Aradur 9506 (Huntsman), Beckopox EH 694 (Allnex), PT 910 and PT 912 (Huntsman), PT 810 and PT 710 (Huntsman), Epikure 3370 (Hexion), D.E.H. 85 (DOW), KD-401 (Kukdo), CYREZ 964 LF/964 RPC (Allnex).

According to an embodiment, the molar ratio of the epoxy functional groups and isocyanate functional groups is between 3:1 and 1:3, in particular between 2:1 and 1:2, further in particular between 1.5:1 and 1:1.5.

According to an embodiment, the powder coating material further comprises a UV absorber and/or a hindered amine light stabilizer (HALS compound) and/or heat stabilizers. Exemplary commercially available UV-, light and heat stabilizers are listed in the following: CHIMASSORB 944 (BASF), CHINOX 1010 (DBC), Richfos 626 (DBC), CHISORB 519 (DBC), CHISORB T2164 (DBC), HOSTANOX P-EPQ P (Clariant), IRGAFOS 126 (BASF), TINUVIN 152 (BASF), TINUVIN 328 (BASF), TINUVIN 405 (BASF), TINUVIN 622 (BASF), TINUVIN 928 (BASF).

Exemplary examples for flow agents are: ALBEMAST 9420 (Synthomer), MODAFLOW POWDER 6000 (Allnex), POWDERMATE 486CFL (Troy chemical), ADDITOL P891 (Allnex).

Exemplary degassing agents are: POWDERMATE 542 DG (Troy), WORLEE ADD 902 (WORLÉE).

According to an embodiment, the powder coating material further comprises at least one catalyst. According to a further embodiment, the at least one catalyst is selected from the group of N-nucleophilic Lewis bases (e.g.: imidazole or imidazoline), ammonium salts, tin compounds, iron compounds, bismuth compounds and malonates. According to an embodiment, the at least one catalyst is selected from the following list: Tetraethylammoniumbenzoate (e.g. Vestagon EP SC 5050), tin acetylacetonate (e.g. TIB KAT 623), tin octoate (e.g. TIB 620, TIB KAT 129, tin(II)octoate), tin octoat-silicon dioxide (e.g. WORLEE-ADD ST 70 100%), dioctyltindilaurate (DOTL, e.g. TIB KAT 216), dibutyltinoxide (DBTO, e.g. TIB KAT 248), Butyltinoxide (MBTO, e.g. TIB KAT 256) bismuthcarboxylate, iron acetylacetonate, diethylmalonate.

The powder coating material (or the housing material) may further comprise process additives, degassing agents, fillers/extender pigments, coloring agents (pigments and dyes), effect pigments, UV- and heat stabilizers, flow agents, UV absorbers, light stabilizers (e.g. HALS), elastomers, process stabilizers and other additives as known by a person skilled in the art of powder coating materials. Exemplary commercially available examples for flow agents and degassing agents are: ALBEMAST 9420 (Synthomer), MODAFLOW POWDER 6000 (Allnex), POWDERMATE 486CFL (Troy chemical), ADDITOL P891 (Allnex), POWDERMATE 542 DG (Troy), WORLEE ADD 902 (WORLÉE)

### Fibers

According to an embodiment, the plurality of fibers form a fabric, e.g. a woven fabric or a nonwoven fabric. The woven fabric may also referred to as fiber cloth. In accordance with an embodiment, the plurality of fibers define a maximum clearance of passages through the plurality of fibers (e.g. the mesh size of a woven or non-woven fabric). This maximum clearance between the plurality of fibers at least inter alia defines a maximum size of powder particle the plurality of fibers will let pass.

According to an embodiment, the fibers of the plurality of fibers are glass fibers, carbon fibers, aramid fibers, or any other suitable type of fibers, or mixtures thereof. Glass fiber are presently particularly preferred.

### Particle size distribution

According to an embodiment, the powder coating material has a particle size distribution with d(50) > 40 µm; and d(90) > 100 µm (µm = micrometer). Herein and as is generally known, a specific value for d(x) (in the above examples x = 50 or x = 90) indicates an amount x % of the particles of the powder coating material. For example, d(50) > 40 µm means that 50 % of the particles of the powder coating material is larger than 40 µm.

According to an embodiment, the mean particle size d(50) is larger than 10 µm, for example larger than 25 µm or larger than 40 µm.

According to an embodiment, a maximum particle size (top cut) of the powder coating material is smaller than 200 µm or larger than 200 µm. According to a further embodiment, the maximum particle size of the powder coating material is smaller than 800 µm, in particular smaller than 650 µm, smaller than 500 µm or, in a still further embodiment, smaller than 400 µm, in particular smaller than 300 µm.

According to a further embodiment, the particle size distribution has a d(50) value larger than 50 µm, further in particular larger than 60 µm. Further, in an embodiment the particle size distribution has a d(90) value larger than 150 µm. According to a further embodiment, the d(50) value is smaller than 220 µm und the d(90) value is smaller than 450 µm.

A relatively small particle size distribution improves the efficiency of the impregnation process. On the one hand, the relatively small amount of small particles prevents a large amount of powder coating material to run through the plurality of fibers. On the other hand, the relatively small maximum particle size provides for a relatively small time period necessary for impregnation of the plurality of fibers with the softened powder coating material, i.e. a relatively small impregnation time.

According to an embodiment, compared to a conventional powder coating, the powder coating material according to embodiments of the herein disclosed subject matter is grinded more coarsely. Further, according to an embodiment the amount of fine particles is smaller compared to conventional powder coating. If too much of the powder coating material runs through the plurality of fibers during impregnation the plurality of fibers may stick to a conveyor of the plurality of fibers. Further, the amount of coarse particles and the top cut is larger than for conventional powder coating.

### Applying powder

According to an embodiment, the powder coating material is applied (in particular evenly applied) to the plurality of fibers by conventional spray guns or, in other embodiments by a needle roller, by rippling or by non-impact printing (e.g. laser printing) or by any other suitable method as known in the art.

According to an embodiment, the powder coating material is uniformly distributed to the plurality of fibers or in other words, the weight of powder coating materials applied to an unit area (e.g. 1 cm² or 1 m²) of the plurality of fibers is essentially constant.

According to an embodiment, the powder coating material is applied to the plurality of fibers in an amount between 100 g/m² and 600 g/m², in particular between 200 g/m² and 500 g/m², further in particular between 250 g/m² and 400 g/m² and further in particular between 260 g/m² and 360 g/m². The ideal amount of powder coating material which is applied to the plurality of fibers depends on various factors, such as density of the powder coating material, composition of the powder coating material, type of fibers, mesh size, desired application, and method of application of the powder coating material. It is routine for a person skilled in the art to vary and thereby optimize the applied amount of powder coating material to the plurality of fibers.

### Impregnating

According to a further embodiment, impregnating (thermal bonding of the powder coating material to the plurality of fibers) includes softening the powder coating material so as to provide coalescence of the initial powder particles and impregnate the plurality of fibers with the softened powder coating material. According to an embodiment the powder is heated to an impregnation temperature, in particular wherein the impregnation temperature is above the glass transition temperature Tg (viscosity η = 10¹² Pas) or, in another embodiment, above the softening point (viscosity η = 10^{6.6} Pas). According to an embodiment, the impregnation temperature is a temperature at which the powder coating material is sufficiently soft so as to flow into the plurality of fibers and thereby impregnate the plurality of fibers, in particular wherein the flow is viscous flow. According to an embodiment, an impregnation temperature is in between 80 °C and 160 °C. According to a further embodiment, the impregnation temperatures is between 95 °C and 150°C, in particular in between 100 °C and 145 °C. Presently, an impregnation temperature between 100 °C and 140°C is particularly preferred.

According to an embodiment, no substantial curing reaction occurs during the impregnation of the plurality of fibers.

According to a further embodiment, a hardening temperature (curing temperature) is above 150 °C, in particular above 160 °C and even further in particular above 170°C and is e.g. between 160 °C and 220 °C or between 150 °C and 185°C.

According to an embodiment, impregnating the plurality of fibers with the powder coating material involves applying an elevated temperature (e.g. as described above) and/or pressure to the powder coating material and the plurality of fibers.

According to a further embodiment, curing the powder coating material involves applying an elevated temperature (e.g. as described above) and/or a pressure and/or electromagnetic radiation, in particular UV radiation, and/or electron beam (EB) radiation to the powder coating material.

According to an embodiment, manufacturing a photovoltaic module comprises applying the powder coating material as a powder having a plurality of powder particles, wherein the impregnation includes heating the powder coating material so as to soften the powder coating material, provide coalescence of the powder particles, and impregnate the plurality of fibers with the softened powder coating material.

According to an embodiment, a pill flow length of the powder coating material is between 30 mm and 300 mm, in particular between 50 mm and 200 mm, further in particular between 80 mm and 160mm and further in particular between 1 10mm and 140mm and wherein the pill flow length is determined by the following method:
(i) pressing an amount of 0.75 grams of the powder coating material into a cylindrical pill with a diameter of 13 mm at a force of 20 kilo Newton for at least 5 seconds;
(ii) putting the pill of powder coating material on a metal sheet at room temperature;
(iii) putting the metal sheet with the pill into a furnace preheated to the potential impregnation temperature (e.g.: 140 °C) and tempering the pill on the metal sheet in a horizontal position for half a minute if the resin includes an acrylic resin component and for one minute if the resin does not include an acrylic resin component;
(iv) tilting the metal sheet to a flowing down angle of 65 degrees and maintaining the metal sheet in this position for 10 minutes at the potential impregnation temperature (e.g. 140 °C);
(v) removing the metal sheet from the furnace, cooling down the metal sheet and the powder coating material in a horizontal position, measuring a maximum length of pill on the metal sheet and taking this maximum length as the pill flow length.

According to an embodiment, the melting temperature of the viscosity decreasing component (i.e. the crystalline or semicrystalline binder component) is below the impregnation temperature. In other words, at the impregnation temperature the viscosity decreasing component is in its liquid state, thereby reducing the viscosity of the entire powder coating material. This may improve impregnation of the plurality of fibers with the powder coating material. However, also the particle size distribution of the powder coating material has an influence on the impregnation of the plurality of fibers.

According to an embodiment, the impregnation temperature is between 100°C and 140°C. In order to provide for a thorough impregnation of the plurality of fibers, there is no substantial hardening of the powder coating material at the impregnation temperature. According to an embodiment, curing of the powder coating material is performed at a temperature below 200°C, e.g. in a press.

According to an embodiment, a (dynamic) viscosity of the uncured powder coating material at 140 °C lies in a range between 5 Pascal seconds (Pas) and 10.000 Pas, in particular between 7 and 5000 Pas, and even further in particular between 10 and 3000 Pas. According to an embodiment, the viscosity in this case is determined as described herein, e.g. by heating the powder coating material from room temperature with a heating rate of 5 Kelvin per minute beyond 140 °C, e.g. up to at least 180°C and/or to a temperature where curing of the powder coating material occurs.

According to an embodiment, a viscosity of the uncured powder coating material at 140 °C lies below 20000 Pascal seconds, in particular below 10000 Pascal seconds, in particular below 7000 Pascal seconds, in particular below 5000 Pascal seconds and further in particular below 4000 Pascal seconds and even further in particular below 3000 Pascal seconds.

According to an embodiment, the viscosity of the powder coating material is measured by heating the powder coating material from room temperature with a heating rate of 5 Kelvin per minute up to at least 180°C, e.g. up to 180°C or in another embodiment, up to 200°C or in particular up to 220 °C. According to an embodiment, rheometer AR 2000 manufactured by TA instrument and an appropriate analysis software may be used to determine the viscosity.

According to an embodiment, the powder coating material exhibits a minimum viscosity, when being heated from room temperature with a heating rate of 5 Kelvin per minute up to at least 180 °C, e.g. up to 180 °C or, in another embodiment, up to 200 °C or in particular up to 220°C and/or to a temperature where curing of the powder coating material occurs. In accordance with an embodiment, the minimum viscosity is in a range between 3 Pascal seconds to 20000 Pascal seconds, in particular in a range between 4 Pascal seconds and 10000 Pascal seconds and further in particular in a range between 5 Pascal seconds and 7000 Pascal seconds, and even further in particular between 6 Pascal seconds and 4000 Pascal seconds.

According to an embodiment, the powder coating material exhibits a minimum viscosity in a temperature range between 100 °C and 170 °C, in particular between 120 and 170°C, wherein said minimum viscosity is below 10000 Pas, in particular below 7000 Pas, further in particular below 5000 Pas, and even further in particular below 4000 (e.g. 7 Pas or 2000 Pas).

According to an embodiment, a gel time of the powder coating material lies in a range between 20 s (seconds) to 400 s, preferably 40 s to 390 s and more preferably 50 s to 390 s at 180 °C when measured according to ÖNORM EN ISO 8130-6.

According to an embodiment, a gel time of the powder coating material lies in a range between 20 s (seconds) to 400 s, preferably 40 s to 150 s and more preferably between 50 s to 100 s at 180 °C when measured according to ÖNORM EN ISO 8130-6.

### Exemplary use and purpose

According to an embodiment, a photovoltaic module comprises a housing material according to one or more embodiments described herein. Embodiments referring to the housing material of the photovoltaic module are also valid for the housing material as such.

According to a further embodiment, the photovoltaic module further comprises at least one photovoltaic cell; wherein the housing material at least partially covers and/or at least partially encapsulates the at least one photovoltaic cell.

According to a further embodiment, the plurality of fibers are impregnated with the powder coating material. For example, according to an embodiment the housing material is provided as a uncured or only partially cured preimpregnated material (prepreg), i.e. a semifinished product, which for example is then provided to the at least one photovoltaic cell at a customer's premises. According to a further embodiment demand, the housing material is provided as a preshaped and cured product.

According to an embodiment, the housing material forms at least a part of a housing of at least one photovoltaic cell. According to an embodiment, the housing material forms at least one layer of at least a part of a housing of at least one photovoltaic cell. According to a further embodiment, the entire housing of at least one photovoltaic cell is formed from the housing material. For example, according to an embodiment the housing material is encapsulating the at least one photovoltaic cell.

According to an embodiment, the photovoltaic module further comprises a composite material wherein the housing material is provided as a part of a layered structure comprising the composite material and the housing material.

According to an embodiment, the housing material forms an outer surface of the photovoltaic module.

According to an embodiment, manufacturing the photovoltaic module comprises providing a semifinished product comprising the plurality of fibers impregnated with the powder coating material, wherein the powder coating material is at least partially uncured; assembling the semifinished product and at least one photovoltaic cell to thereby provide a semifinished module; and curing the powder coating material.

According to a further embodiment, curing the powder coating material comprises subjecting the powder coating material to an elevated temperature, in particular a temperature sufficient to cure the powder coating material, e.g. in a heatable press or laminator.

According to an embodiment, manufacturing the photovoltaic module further comprises pressing the semifinished product and the at least one photovoltaic cell towards each other. According to a further embodiment, at least one layer may be located between the semifinished product and the photovoltaic cell, e.g. at least one foil made from metal and/or at least one polymer film.

According to an embodiment, the semifinished product comprises at least one further element, in particular wherein the at least one further element is a film, foil or coating, in particular a powder coating.

According to a further embodiment, manufacturing the photovoltaic module further comprises providing the plurality of fibers as a part of a layered structure; in particular wherein the layered structure comprises the plurality of fibers impregnated with the powder coating material and a composite material, in particular a composite material comprising a fabric, in particular a fabric comprising a structure which is different from the structure of the plurality of fibers.

According to a further embodiment, manufacturing the photovoltaic module further comprises providing a first prepreg, comprising a first plurality of fibers, in particular wherein a first prepreg comprises a first plurality of fibers impregnated with a first powder coating material and providing a second prepreg, comprising a second plurality of fibers, in particular wherein a second prepreg comprises a second plurality of fibers impregnated with a second powder coating material, wherein the first and second plurality of fibers and/or the first and second powder coating material may be the same or different and wherein at least one prepreg corresponds to embodiments as described within this application. According to another embodiment, more than two prepregs may be used for manufacturing the photovoltaic module.

### Pigments

According to an embodiment, the powder coating material comprises at least one pigment, in particular a color pigment. According to a further embodiment, the housing material is located on a back side of the photovoltaic module, in particular wherein the housing material comprises a pigment, e.g. a color pigment or an effect pigment, in particular a metallic pigment. According to an embodiment, the back side of the photovoltaic module faces away from the active surface of the at least one photovoltaic cell of the module. Worded differently, the back side faces away from the illumination (e.g. the sun).

According to an embodiment, the housing material is a housing material for (or of) a back side of the photovoltaic module. In particular in case the housing material forms a back side of the photovoltaic module the housing material (in particular the powder coating material) may comprise a pigment, e.g. a color pigment.

According to a further embodiment, the powder coating material / housing material does not contain any pigment, in particular any color pigment. According to an embodiment, the housing material without color pigments is used for a front side of the photovoltaic module. In other words, a transparent housing material is used for a front side of the photovoltaic module.

### Examples

In accordance with an embodiment, in the exemplary formulations below an epoxy resin constitutes a main portion of the binder system. A typical example for epoxy resin is a Bisphenol A (BPA) based resin. An epoxy resin is to be distinguished from an resin comprising an epoxy group, e.g. an acrylic resin comprising epoxy functional groups, in particular a glycidylmethacrylate (GMA) resin.

According to an embodiment, the powder coating material is a polyester/epoxy hybrid powder coating which comprises as main components of the binder epoxy resin and a functional polyester, e.g. a COOH functional polyester. Such a system does not necessarily need a hardener because the epoxy resin may cross-link with the COOH functional polyester. Typical ratios are between 30:70 and 70:30.

The exemplary formulations below are
A) an epoxy powder coating
B) an epoxy powder coating with 10 wt% (semi)-crystalline OH polyester
C) an epoxy / polyester hybrid powder coating comprising epoxy resin and two different COOH functional polyesters
D) an epoxy clear powder coating

### Formulation A)

| *Material Name* | | Wt% | Specification |
|---|---|---|---|
| D.E.R. 642U-20 EPOXY RESIN | novolac modified, solid epoxy resin | 45.1 | EEW (g/eq): |
| | | | 520-560 |
| | | | Softening point: 92-98 °C |
| | | | Tg:48°C |
| CRELAN EF 403 | Polyisocyanate | 29.1 | NCO content: 13.5% |
| | | | Tg: 40-55 °C |
| LUVOTIX R400 | Castor oil derivative | 2.0 | Viscosity decreasing component |
| TI-SELECT TS6200 | pigment | 20.49 | |
| Additives | | Balance | |

Formulation A contains only a single epoxy resin which was modified with Novolac. Novolac is a phenolic resin (i.e. a polyol). The system is hardened with an isocynate hardener.

### Formulation B)

| *Material* | | Wt% | Specification |
|---|---|---|---|
| KUKDO EPOXY ST- 5080 | Hydrogenated BPA Type Epoxy Resin | | EEW (g/eq): 550-650 |
| | | | Softening point: 78-88 °C |
| | | 35.00 | Tg: 40°C |
| *SIRALES PE 6215*/*F* | *Hydroxylated polyester resin* | | *OH value: 35-50 mg KOH*/*g* |
| | | *10.00* | *Tg: 58* °*C* |
| VESTAGON EP-BF 9030 | Polyisocyanate | | NCO content: 12.0-13.5% |
| | | 30.00 | Tg: ≥50 °C |
| LUVOTIX R 400 | Castor oil derivative | 2.00 | Viscosity decreasing component |
| VESTAGON EP-SC 5050 | catalyst | 0.25 | |
| 2-ETHYLIMIDAZOL | catalyst | 0.10 | |
| TI-SELECT TS6200 | pigment | 18.84 | |
| Additives | | Balance | |

Formulation B) is similar to formulation A) but contains in addition 10 % of a crystalline OH functional polyester resin. In accordance with an embodiment, the polyester resin is a crystalline resin with a melting temperature at or below the impregnation temperature at which the prepreg is formed. Due to the sharp viscosity decrease upon melting, the viscosity of the entire powder coating material rapidly reduces when the temperature of the powder coating material is increased beyond the melting temperature.

### Formulation C)

| *Material Name* | | Wt% | Specification |
|---|---|---|---|
| KUKDO EPOXY ST- 5080 | Hydrogenated BPA Type Epoxy Resin | 24 | EEW (g/eq): 550-650 |
| | | | Softening point: 78-88 °C |
| | | | Tg:40°C |
| Polyester Resin | saturated, carboxyl functional resin | 38.8 | Acid value: 50 mg KOH/g |
| | | | Visc. at 200°C: 3.0 Pas |
| | | | Tg:59°C |
| SIRALES PE 5900 | Carboxyl functional (semi)-crystalline resin | 10 | Acid value: 28-36 mg KOH/g |
| | | | Melting range: 105-120°C |
| | | | Visc. at 125°C: 1500 mPas |
| VESTAGON EP-SC 5050 | Tetraalkylammo niumcarboxylate (TAAC) catalyst | 0.5 | TAAC content: 45% |
| TI-SELECT TS6200 | pigment | 20.193 | |
| Additives | | Balance | |

Formulation C) is a epoxy/polyester hybrid system comprising an epoxy resin and two COOH functional polyesters. According to an embodiment, the powder coating material comprises an amorphous COOH polyester (Tiger resin in formulation C)) and an at least partially crystalline COOH polyester (Sirales PE 5900 in formulation C)). In formulation C) the amount of epoxy resin is 24 %. No further hardeners are included. Other catalysts (other than the ammonium catalyst) may be used. The other components are additives and pigments.

### Formulation D)

| *Material Name* | | Wt% | Specification |
|---|---|---|---|
| KukdoEpoxy ST 4100 D | Hydrogenated BPA Type Epoxy Resin | 85.2 | EEW (g/eq): 900-1100 |
| | | | Softening point: 95-110 °C |
| | | | Tg:48°C |
| Aradur 3380-1 | Anhydrid curing agent | 11.7 | AV: 500-540 mg KOH/g |
| | | | Softening point: 95-110 °C |
| | | | Tg:55 °C |
| Additives | | Balance | |

Formulation D contains only a single epoxy resin which was modified with hydrogenated BPA epoxy resin. The system is hardened with an anhydrid hardener.

### Summary of examples

| **Formulation** | **Tg / [°C]** | **gel time ( 180°C) / [s]** | **pill flow (140°C) / [mm]** | **dynamic viscosity (140°C) / [Pas]** | **dynamic viscosity (125°C) / [Pas]** | **minimum viscosity / [Pas]** | **Tempera ture of minimum viscosity / [°C]** |
|---|---|---|---|---|---|---|---|
| Epoxy (A) | 48 | 303 | 184 | 2902 | 4499 | 1471 | 164.4 |
| Epoxy + crystalline polyester (B) | 44 | 58 | 119 | 1356 | 713.7 | 669.8 | 121.1 |
| Hybrid (C) | 38 | 386 | 99 | 16.19 | 30.30 | 6.896 | 167.7 |
| Hybrid PV (D) | 42 | 117 | 145 | 54.29 | 55.39 | 43.81 | 136.1 |
| **COMPARATIVE** Epoxy (E) (see below) | 58 | 23 | 15 | 1838000 | 36240 | 14820 | 115.4 |

### Comparative Example

### Formulation (E)

| **Comparative epoxy powder coating material** | | | |
|---|---|---|---|
| **Material Name** | | **Wt%** | **Specification** |
| | | | EEW: 410-440 g/eg |
| OUDRA Therm HPC 6510 | Epoxy Resin | 74.93 | Softening point:105-114 °C |
| 2-ETHYLIMIDAZOL | catalyst | 0.97 | |
| TIOXIDE TR81 | pigment | 20 | |
| Additives | | Balance | |

### General

According to embodiments of the first aspect, the housing material is adapted for providing the functionality or features of one or more of the herein disclosed embodiments and/or for providing the functionality or features as required by one or more of the herein disclosed embodiments, in particular of the embodiments of the second, third, fourth and fifth aspect disclosed herein.

According to embodiments of the second aspect, the photovoltaic module is adapted for providing the functionality or features of one or more of the herein disclosed embodiments and/or for providing the functionality or features as required by one or more of the herein disclosed embodiments, in particular of the embodiments of the second, third, fourth and fifth aspect disclosed herein.

According to embodiments of the third aspect, the use of a powder coating material is adapted for providing the functionality or features of one or more of the herein disclosed embodiments and/or for providing the functionality or features as required by one or more of the herein disclosed embodiments, in particular of the embodiments of the second, third, fourth and fifth aspect disclosed herein.

According to embodiments of the fourth aspect, the method is adapted for providing the functionality or features of one or more of the herein disclosed embodiments and/or for providing the functionality or features as required by one or more of the herein disclosed embodiments, in particular of the embodiments of the second, third, fourth and fifth aspect disclosed herein.

According to embodiments of the fifth aspect, the powder coating material is adapted for providing the functionality or features of one or more of the herein disclosed embodiments and/or for providing the functionality or features as required by one or more of the herein disclosed embodiments, in particular of the embodiments of the second, third, fourth and fifth aspect disclosed herein.

In the above there have been described and in the following there will be described exemplary embodiments of the subject matter disclosed herein with reference to a housing material, a photovoltaic module, a use of a powder coating material, a method, and a powder coating material. It has to be pointed out that of course any combination of features relating to different aspects of the herein disclosed subject matter is also possible. In particular, some features have been or will be described with reference to device type embodiments (e.g. relating to a housing material, a photovoltaic module or a powder coating material) whereas other features have been or will be described with reference to method type embodiments (e.g. relating to a method or a use of a powder coating material). However, a person skilled in the art will gather from the above and the following description that, unless otherwise notified, in addition to any combination of features belonging to one aspect also any combination of features relating to different aspects or embodiments, for example even combinations of features of device type embodiments and features of the method type embodiments are considered to be disclosed with this application. In this regard, it should be understood that any method feature derivable from a corresponding explicitly disclosed device feature should be based on the respective function of the device feature and should not be considered as being limited to device specific elements disclosed in conjunction with the device feature. Further, it should be understood that any device feature derivable from a corresponding explicitly disclosed method feature can be realized based on the respective function described in the method with any suitable device disclosed herein or known in the art.

The aspects and embodiments defined above and further aspects and embodiments of the herein disclosed subject matter are apparent from the examples to be described hereinafter and are explained with reference to the drawings, but to which the invention is not limited. The aforementioned definitions and comments are in particular also valid for the following detailed description and vice versa.

Based on the aforementioned principles, embodiments and examples or, in the following a more detailed example an implementation of the herein disclosed subject matter is provided. However, a person of ordinary skill in the art will understand that particular embodiments described hereinafter may be replaced by alternative embodiments described above without departing from the scope of the herein disclosed subject matter as defined by the appended claims.

### BRIEF DESCRIPTION OF THE DRAWINGS

Fig. 1 and Fig. 2 illustrate the manufacturing of a housing material 100 for a photovoltaic module according to embodiments of the herein disclosed subject matter.
Fig. 3 shows a photovoltaic module according to embodiments of the herein disclosed subject matter.

### DETAILED DESCRIPTION

The illustration in the drawings is schematic. It is noted that in different figures, similar or identical elements are provided with the same reference signs. Accordingly, the description of the similar or identical features is not repeated in the description of subsequent figures in order to avoid unnecessary repetitions. Rather, it should be understood that the description of these features in the preceding figures is also valid for the subsequent figures unless explicitly noted otherwise.

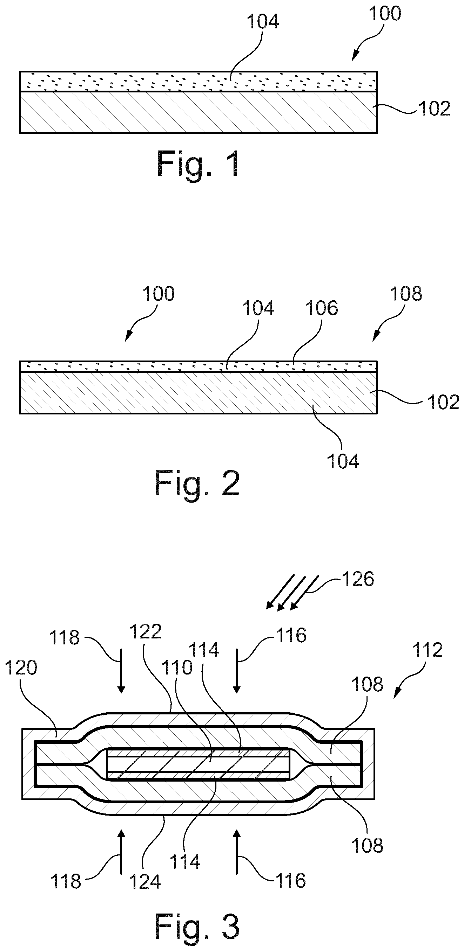

Fig. 1 and Fig. 2 illustrate the manufacturing of a housing material 100 for a photovoltaic module according to embodiments of the herein disclosed subject matter.

In particular, Fig. 1 shows a plurality of fibers 102, provided e.g. in the form of a fleece or cloth. In accordance with an embodiment, for impregnating the plurality of fibers 102 a powder coating material 104 provided in the form of a plurality of powder particles.

According to an embodiment, impregnating the plurality of fibers 102 with the powder coating material 104 includes applying to a plurality of fibers 102 the powder coating material 104 as a powder having a plurality of powder particles and heating the powder coating material 104 so as to soften the powder coating material 104. According to an embodiment, the powder coating material 104 is provided in the form of a powder layer which is deposited on the plurality of fibers 102, e.g. as shown in Fig. 1. Upon softening, the softened powder coating material 104 penetrates into voids between the plurality of fibers (not shown in Fig. 1).

The result is shown in Fig. 2, showing the housing material 100 in the state of a semifinished product 108 (referred to as semifinished product since the powder coating material is not yet cured) having the plurality of fibers 102 impregnated with the powder coating material 104. According to an embodiment, the powder coating material 104 also forms a layer 106, in particular a continuous layer, of powder coating material on the impregnated plurality of fibers 102. According to an embodiment, the layer 106 forms a smooth surface. For example, according to an embodiment, a first part of the powder coating material 104 penetrates into the voids between the plurality of fibers 102 whereas a second part of the powder coating material 104 remains on the plurality of fibers 102, thus forming the layer 106 of powder coating material on the (impregnated) plurality of fibers 102.

In accordance with an embodiment, the softened powder coating material 104 is uncured or is at least partially uncured. In particular, according to an embodiment the plurality of fibers 102 impregnated with the powder coating material, e.g. as shown in Fig. 2, provides a semifinished product 108 comprising the plurality of fibers impregnated with the (at least partially uncured) powder coating material 104.

Fig. 3 shows a photovoltaic module 112 according to embodiments of the herein disclosed subject matter.

In accordance with a further embodiment, the semifinished product 108 and at least one photovoltaic cell 110 are assembled to provide the photovoltaic module 112. According to an embodiment, the semifinished product 108 entirely encloses the photovoltaic cell 110, e.g. as shown in Fig. 3. However, it should be understood that the configuration shown in Fig. 3 is just one of several possibilities.

According to a further embodiment, the photovoltaic module 112, and in particular the at least partially uncured powder coating material 104 thereof, is subjected to curing. For example, according to an embodiment, the photovoltaic module 112 is subjected to heat 118 which raises the temperature of the powder coating material to an elevated temperature, i.e. a curing temperature, at which curing occurs.

According to a further embodiment, during curing the photovoltaic module 112 is subjected to pressure 116, pressing the semifinished product 108 and the at least one photovoltaic cell 110 towards each other.

According to an embodiment, the semifinished product 108, i.e. the plurality of fibers impregnated with the powder coating material, results after curing in a finished product.

According to a further embodiment, at least one further element 114, e.g. a film is provided between the semifinished product 108 and the photovoltaic cell 110, e.g. as shown in Fig. 3. For example, according to an embodiment, the semifinished product 108 comprises at least one further element 114, e.g. a film such as a polymer film or a metal foil on at least one main surface of the semifinished products 108, e.g. as shown in Fig. 3. In this sense, pressing the semifinished product 108 and the at least one photovoltaic cell 110 towards each other does not necessarily mean that the photovoltaic cell 110 and the semifinished product 108 are in direct contact with each other but rather also includes an embodiment wherein a further element 114 is located between the semifinished product 108 and the photovoltaic cell 110. According to a further embodiment, the semifinished product 108 and the photovoltaic cell 110 are in direct contact with each other (omitting the further element 114, not shown in Fig. 3).

According to a further embodiment, the at least one further element includes a further element 120 (e.g. a coating) which is provided on an outer surface of the semifinished product 108. According to a further embodiment, the further element 120 is provided on the finished (cured) product, e.g. as shown in Fig. 3. According to an embodiment, the further element 120 provides an outer surface of the photovoltaic module 112. According to a further embodiment, the further element 120 is formed from a weather resistant material, for example, the further element 120 may be an acrylic powder coating or a material layer which comprises an acrylic powder coating. According to an embodiment, the at least one further element may be a plastic film or a further prepreg, e.g. a further prepreg comprising an acrylic powder coating.

Generally, the at least one further element 114, 120 is at least one further material layer, e.g. a plastic film, a further prepreg or, on a backside 124 of the photovoltaic module 112, a metallic foil, a polymer foil etc.

According to an embodiment, the photovoltaic module 112 has a front side 122 and a backside 124 pointing into a direction opposite the front side 122. According to a further embodiment the front side 122 is configured for receiving light, indicated at 126 in Fig. 3 and allowing the light 126 to propagate to the at least one photovoltaic cell 110, e.g. by configuring all layers between an outer surface of the front side 122 photovoltaic module 112 and the photovoltaic cell 110 to be transparent. According to an embodiment the photovoltaic cell 110 is configured for receiving the light 126 and the photovoltaic cell 110 provides, in response hereto, electrical power.

According to an embodiment, the backside 124 of the photovoltaic module 112 and in particular the semifinished product (or, after curing, the finished product) on the backside 124 of the photovoltaic module 112 comprises a pigment, e.g. a pigment in accordance with embodiments of the herein disclosed subject matter.

According to an embodiment, the semifinished product 108 may be referred to as housing material for (or of) the photovoltaic module. According to a further embodiment, after curing of the semifinished product 108 the resulting finished product may also be referred to as housing material or may be referred to as cured housing material. In other words, the term "housing material" includes the cured as well as the uncured housing material.

According to an embodiment, the photovoltaic module 112 comprising the uncured housing material may also be referred to as uncured photovoltaic module or, in case the housing material is cured may also be referred to as cured photovoltaic module. In other words, the term "photovoltaic module" includes the uncured as well as the cured photovoltaic module.

It should be noted that any entity disclosed herein (e.g. components, elements, modules, products and devices) are not limited to a dedicated entity as described in some embodiments. Rather, the herein disclosed subject matter may be implemented in various ways and with various granularity while still providing the specified functionality. Further, it should be noted that according to embodiments a separate entity (e.g. components, elements, modules, products and devices) may be provided for each of the functions disclosed herein. According to other embodiments, an entity (e.g. components, elements, modules, products and devices) is configured for providing two or more functions as disclosed herein. According to still other embodiments, two or more entities are configured for providing together a function as disclosed herein.

Further, it should be noted that while the exemplary implementations of embodiments in the drawings comprise a particular combination of several embodiments of the herein disclosed subject matter, any other combination of embodiment is also possible and is considered to be disclosed with this application and hence the scope of the herein disclosed subject matter extends to all alternative combinations of two or more of the individual features mentioned or evident from the text. All of these different combinations constitute various alternative examples of the invention.

It should be noted that the term "comprising" does not exclude other elements or steps and the "a" or "an" does not exclude a plurality. Further, the term "comprising" includes the meaning "inter alia comprising" as well as the meaning "consisting of". Elements described in association with different embodiments may be combined. It should also be noted that reference signs in the claims should not be construed as limiting the scope of the claims.

According to an embodiment the term "adapted to" includes inter alia the meaning "configured to".

In order to recapitulate some of the above described embodiments of the present invention one can state:
A housing material (108) for a photovoltaic module comprises a plurality of fibers and powder coating material, wherein the powder coating material comprises an epoxy resin with an epoxy equivalent weight in between 150 g/eq. and 1800 g/eq, wherein a glass transition temperature of the powder coating material is at least 30 °C measured with Differential Scanning Calorimetry at a heating rate of 20 K / min.

## Claims

1. A housing material (108) for a photovoltaic module comprising a plurality of fibers and powder coating material (104),
**characterized in that**:
the powder coating material (104) comprises an epoxy resin with an epoxy equivalent weight in between 150 g/eq. and 1800 g/eq;
wherein the epoxy resin is selected from bisphenol epoxy resin, polyphenol epoxy resin, novolak epoxy resin, phenolic epoxy resin, hydrogenated bisphenol epoxy resin, hydrogenated polyphenol epoxy resin, halogenated bisphenol epoxy resin, halogenated polyphenol epoxy resin, (cyclo)aliphatic epoxy resin and mixtures thereof; and
wherein a glass transition temperature of the uncured powder coating material (104) is at least 30 °C, measured with Differential Scanning Calorimetry at a heating rate of 20 K / min.

2. The housing material (108) according to claim 1, further comprising one or more of the following:
the epoxy equivalent weight is between 200 g/eq. and 800 g/eq, in particular between 400 and 700 g/eq and further in particular between 450 g/eq and 650 g/eq;
the epoxy resin accounts for at least 1 wt%, in particular at least 10 wt%, in particular at least 30 wt%, in particular at least 50 wt% and even further in particular at least 60 wt% of the total weight of the powder coating material (104).

3. The housing material (108) according to anyone of the preceding claims, wherein a pill flow length of the powder coating material (104) is between 30 mm and 300 mm, in particular between 50 mm and 200 mm, further in particular between 80 mm and 160 mm and further in particular between 110 mm and 140 mm and wherein the pill flow length is determined by the following method:
(i) pressing an amount of 0.75 grams of the powder coating material (104) into a cylindrical pill with a diameter of 13 mm at a force of 20 kilo Newton for at least 5 seconds;
(ii) putting the pill of powder coating material (104) on a metal sheet at room temperature;
(iii) putting the metal sheet with the pill into a furnace preheated to the potential impregnation temperature and tempering the pill on the metal sheet in a horizontal position for half a minute if the resin includes an acrylic resin component and for one minute if the resin does not include an acrylic resin component;
(iv) tilting the metal sheet to a flowing down angle of 65° and maintaining the metal sheet in this position for 10 minutes at the potential impregnation temperature;
(v) removing the metal sheet from the furnace, cooling down the metal sheet and the powder coating material (104) in a horizontal position, measuring a maximum length of pill on the metal sheet and taking this maximum length as the pill flow length.

4. The housing material (108) according to anyone of the preceding claims wherein
a viscosity of the uncured powder coating material (104) at 140 °C lies below 20000 Pascal seconds, in particular below 10000 Pascal seconds, in particular below 7000 Pascal seconds, in particular below 5000 Pascal seconds and further in particular below 4000 Pascal seconds and even further in particular below 3000 Pascal seconds;
and/or
wherein the powder coating material (104) exhibits a minimum viscosity, when being heated from room temperature with a heating rate of 5 Kelvin per minute up to at least 180°C and/or to a temperature where curing of the powder coating material occurs, wherein the minimum viscosity is in a range between 3 Pascal seconds to 20000 Pascal seconds, in particular in a range between 4 Pascal seconds and 10000 Pascal seconds and further in particular in a range between 5 Pascal seconds and 7000 Pascal seconds;
and/or
wherein a gel time of the powder coating material lies in a range between 20 seconds - 400 seconds, preferably 40 seconds to 200 seconds and more preferably 50 seconds - 100 seconds at 180°C when measured according to ÖNORM EN ISO 8130-6.

5. The housing material (108) according to anyone of the preceding claims wherein the powder coating material (104) further comprises a polyester resin, wherein a glass transition temperature of the polyester resin is least 30 °C, in particular at least 40 °C and further in particular at least 50 °C and wherein, the polyester resin is preferably amorphous.

6. The housing material (108) according to claim 5, wherein the polyester resin comprises hydroxyl groups and/or carboxyl groups;
in particular wherein a hydroxyl value of the polyester resin is between 10 and 300 mg KOH/g and/or the carboxyl value of the polyester resin is between 5 and 100 mg KOH/g;
and/or
in particular wherein the polyester resin accounts for 1 to 80 wt%, in particular 3 to 60 wt%, in particular 5 to 50 wt% and even further in particular 7 to 40 wt% of the total weight of the powder coating material (104).

7. The housing material (108) according to anyone of the preceding claims
wherein the powder coating material (104) comprises up to 50 wt%, in particular up to 30 wt% further in particular up to 15 wt% and further in particular up to 10 wt% of a viscosity-decreasing component with respect to the total weight of the powder coating material (104); and
in particular wherein the viscosity decreasing component is selected from a (semi)crystalline binder component, an oil, in particular castor oil or a derivative thereof, polyethylene (PE), in particular linear low density (LLD) PE, polytetrahydorfurane (poly-THF), thermoplastic elastomers, in particular, thermoplastic polyurethane (TPU), polypropylene, in particular atactic polypropylene, and mixtures and/or derivatives thereof.

8. The housing material (108) according to anyone of the preceding claims wherein the powder coating material comprises at least one of a (semi)crystalline binder component and at least one curing agent;
in particular wherein the (semi)crystalline binder component comprises epoxy and/or polyester resin;
further in particular wherein the at least one curing agent has a softening point at a temperature of 150°C or below.

9. The housing material (108) according to claim 8 wherein the at least one curing agent is selected from the group of isocyanate, blocked isocyanate, latent iscocyanate, uretdion, amines, epoxides, carboxylic acids and anhydrides, hydroxylalkylamids (so called PRIMIDs), TGIC, glycidyl acrylates, and mixtures of two or more of these components.

10. The housing material (108) according to any one of claims 1 to 9 wherein the powder coating material (104) comprises at least one pigment, in particular a color pigment.

11. Photovoltaic module (112) comprising a housing material (108) according to anyone of the preceding claims.

12. Powder coating material (104) for impregnating a plurality of fibers **characterized in that** it comprises
an epoxy resin with an epoxy equivalent weight in between 150 g/eq. and 1800 g/eq; wherein
the epoxy resin is selected from bisphenol epoxy resin, polyphenol epoxy resin, novolak epoxy resin, phenolic epoxy resin, hydrogenated bisphenol epoxy resin, hydrogenated polyphenol epoxy resin, halogenated bisphenol epoxy resin, halogenated polyphenol epoxy resin, (cyclo)aliphatic epoxy resin and mixtures thereof; and wherein
a glass transition temperature of the powder coating material (104) is at least 30 °C, measured with Differential Scanning Calorimetry at a heating rate of 20 K / min.

13. The powder coating material (108) according to claim 12, further comprising one or more of the following:
the epoxy equivalent weight is between 200 g/eq. and 800 g/eq, in particular between 400 and 700 g/eq and further in particular between 450 g/eq and 650 g/eq;
the epoxy resin accounts for at least 1 wt%, in particular at least 10 wt%, in particular at least 30 wt%, in particular at least 50 wt% and even further in particular at least 60 wt% of the total weight of the powder coating material (104);
the glass transition temperature of the powder coating material (104) is at least 40 °C, in particular at least 50 °C.

14. Method for manufacturing a fiber-reinforced plastic, the method comprising
providing a plurality of fibers;
applying to the plurality of fibers a powder coating material according to anyone of claims 12 or 13, wherein the powder coating material is applied as a powder having a plurality of powder particles.

15. A use of a powder coating material (104) according to anyone of claims 12 or 13 for manufacturing a fiber reinforced plastic.

## Patentansprüche

1. Ein Gehäusematerial (108) für ein Fotovoltaikmodul, aufweisend eine Mehrzahl von Fasern und ein pulverförmiges Beschichtungsmaterial (104),
**dadurch gekennzeichnet, dass**:
das pulverförmige Beschichtungsmaterial (104) ein Epoxidharz mit einem Epoxid-Äquivalentgewicht zwischen 150 g/eq und 1800 g/eq aufweist;
wobei das Epoxidharz ausgewählt ist aus Bisphenol Epoxidharz, Polyphenol Epoxidharz, Novolak Epoxidharz, phenolischem Epoxidharz, hydriertem Bisphenol Epoxidharz, hydriertem Polyphenol Epoxidharz, halogeniertem Bisphenol Epoxidharz, halogeniertem Polyphenol Epoxidharz, (cyclo)aliphatischem Epoxidharz und Mischungen daraus; und
wobei eine Glasübergangstemperatur des nicht ausgehärteten pulverförmigen Beschichtungsmaterials (104) mindestens 30 °C ist, gemessen mit Differenzial-Scanning-Kalorimetrie bei einer Erwärmungsrate von 20 K/min.

2. Das Gehäusematerial (108) gemäß Anspruch 1, ferner aufweisend eines oder mehrere der folgenden:
das Epoxid-Äquivalentgewicht ist zwischen 200 g/eq und 800 g/eq, insbesondere zwischen 400 und 700 g/eq, und weiter insbesondere zwischen 450 g/eq und 650 g/eq;
das Epoxidharz macht mindestens 1 Gew. %, insbesondere mindestens 10 Gew. %, insbesondere mindestens 30 Gew. %, insbesondere mindestens 50 Gew. % und weiter sogar insbesondere mindestens 60 Gew. % des Gesamtgewichts des pulverförmigen Beschichtungsmaterials (104) aus.

3. Das Gehäusematerial (108) gemäß einem beliebigen der vorangehenden Ansprüche, wobei eine Pillenflusslänge des pulverförmigen Beschichtungsmaterials (104) zwischen 30 mm und 300 mm ist, insbesondere zwischen 50 mm und 200 mm, weiter insbesondere zwischen 80 mm und 160 mm, und weiter insbesondere zwischen 110 mm und 140 mm, und wobei die Pillenflusslänge mittels des folgenden Verfahrens bestimmt wird:
(i) Pressen einer Menge von 0,75 g des pulverförmigen Beschichtungsmaterials (104) zu einer zylindrischen Pille mit einem Durchmesser von 13 mm mit einer Kraft von 20 Kilonewton für mindestens 5 Sekunden;
(ii) Platzieren der Pille aus dem pulverförmigen Beschichtungsmaterial (104) auf einem Metallblech bei Raumtemperatur;
(iii) Platzieren des Metallblechs mit der Pille in einem Ofen, welcher zu der potentiellen Imprägnierungstemperatur vorgeheizt ist, und Temperieren der Pille auf dem Metallblech in einer horizontalen Position für eine halbe Minute, falls das Harz eine Acrylharzkomponente enthält, und für 1 Minute, falls das Harz keine Acrylharzkomponente enthält;
(iv) Kippen des Metallblechs zu einem Herunterfließwinkel von 65° und Halten des Metallblechs in dieser Position für 10 Minuten bei der potentiellen Imprägnierungstemperatur;
(v) Entnehmen des Metallblechs aus dem Ofen, Herunterkühlen des Metallblechs und des pulverförmigen Beschichtungsmaterials (104) in einer horizontalen Position, Messen einer maximalen Länge der Pille auf dem Metallblech und Annehmen dieser maximalen Länge als die Pillenflusslänge.

4. Das Gehäusematerial (108) gemäß einem beliebigen der vorangehenden Ansprüche, wobei
eine Viskosität des nicht ausgehärteten pulverförmigen Beschichtungsmaterials (104) bei 140 °C unter 20.000 Pascalsekunden, insbesondere unter 10.000 Pascalsekunden, insbesondere unter 7000 Pascalsekunden, insbesondere unter 5000 Pascalsekunden, und weiter insbesondere unter 4000 Pascalsekunden und sogar weiter insbesondere unter 3000 Pascalsekunden liegt;
und/oder
wobei das pulverförmige Beschichtungsmaterial (104) eine minimale Viskosität zeigt, wenn es von der Raumtemperatur mit einer Erwärmungsrate von 5 K/min bis zu mindestens 180 °C und/oder zu einer Temperatur, bei welcher das Aushärten des pulverförmigen Beschichtungsmaterials auftritt, erwärmt wird, wobei die minimale Viskosität in einem Bereich zwischen 3 Pascalsekunden und 20.000 Pascalsekunden, insbesondere in einem Bereich zwischen 4 Pascalsekunden und 10.000 Pascalsekunden, und weiter insbesondere in einem Bereich zwischen 5 Pascalsekunden und 7000 Pascalsekunden ist;
und/oder
wobei eine Gelzeit des pulverförmigen Beschichtungsmaterials in einem Bereich zwischen 20 Sekunden und 400 Sekunden, bevorzugt 40 Sekunden und 200 Sekunden, und weiter bevorzugt 50 Sekunden und 100 Sekunden bei 180 °C liegt, wenn sie gemäß der ÖNORM EN ISO 8130-6 gemessen wird.

5. Das Gehäusematerial (108) gemäß einem beliebigen der vorangehenden Ansprüche, wobei das pulverförmige Beschichtungsmaterial (104) ferner ein Polyesterharz aufweist, wobei eine Glasübergangstemperatur des Polyesterharzes mindestens 30 °C, insbesondere mindestens 40 °C, und weiter insbesondere mindestens 50 °C ist, und wobei das Polyesterharz bevorzugt amorph ist.

6. Das Gehäusematerial (108) gemäß Anspruch 5, wobei das Polyesterharz Hydroxylgruppen und/oder Carboxylgruppen aufweist;
insbesondere wobei ein Hydroxylwert des Polyesterharzes zwischen 10 und 300 mg KOH/g ist, und/oder der Carboxylwert des Polyesterharzes zwischen 5 und 100 mg KOH/g ist;
und/oder
insbesondere wobei das Polyesterharz 1 bis 80 Gew. %, insbesondere 3 bis 60 Gew. %, insbesondere 5 bis 50 Gew. %, und ferner insbesondere sogar 7 bis 40 Gew. %, des Gesamtgewichts des pulverförmigen Beschichtungsmaterials (104) ausmacht.

7. Das Gehäusematerial (108) gemäß einem beliebigen der vorangehenden Ansprüche,
wobei das pulverförmige Beschichtungsmaterial (104) bis zu 50 Gew. %, insbesondere bis zu 30 Gew. %, ferner insbesondere bis zu 15 Gew. %, und weiter insbesondere bis zu 10 Gew. % einer viskositätsverringernden Komponente in Bezug auf das Gesamtgewicht des pulverförmigen Beschichtungsmaterials (104) aufweist; und
insbesondere wobei die viskositätsverringernde Komponente ausgewählt ist aus einer (semi)kristallinen Binderkomponente, einem Öl, insbesondere Castoröl oder einem Derivat davon, Polyethylen (PE), insbesondere einem linearen Niederdichte (LLD) PE, Polytetrahydorfuran (Poly-THF), thermoplastischen Elastomeren, insbesondere thermoplastischem Polyurethan (TPU), Polypropylen, insbesondere ataktischem Polypropylen, und Mischungen und/oder Derivaten davon.

8. Das Gehäusematerial (108) gemäß einem beliebigen der vorangehenden Ansprüche, wobei das pulverförmige Beschichtungsmaterial mindestens eines von einer (semi)kristallinen Binderkomponente und mindestens einem Aushärtungsmittel aufweist;
insbesondere wobei die (semi)kristalline Binderkomponente Epoxid und/oder Polyesterharz aufweist;
weiter insbesondere wobei das mindestens eine Aushärtungsmittel einen Erweichungspunkt bei einer Temperatur von 150 °C oder darunter hat.

9. Das Gehäusematerial (108) gemäß Anspruch 8, wobei das mindestens eine Aushärtungsmittel ausgewählt ist aus der Gruppe von Isocyanat, blockiertem Isocyanat, latentem Isocyanat, Uretdion, Aminen, Epoxiden, Carboxylsäuren und Anhydriden, Hydroxylalkylamiden (sogenannten PRIMIDs), TGIC, Glycidyl-Acrylaten, und Mischungen aus zwei oder mehr dieser Komponenten.

10. Das Gehäusematerial (108) gemäß einem beliebigen der Ansprüche 1 bis 9, wobei das pulverförmige Beschichtungsmaterial (104) mindestens ein Pigment, insbesondere ein Farbpigment, aufweist.

11. Fotovoltaikmodul (112) aufweisend ein Gehäusematerial (108) gemäß einem beliebigen der vorangehenden Ansprüche.

12. Pulverförmiges Beschichtungsmaterial (104) zum Imprägnieren einer Mehrzahl von Fasern,
**dadurch gekennzeichnet, dass** es aufweist
ein Epoxidharz mit einem Epoxid-Äquivalentgewicht zwischen 150 g/eq und 1800 g/eq;
wobei
das Epoxidharz ausgewählt ist aus Bisphenol Epoxidharz, Polyphenol Epoxidharz, Novolak Epoxidharz, phenolischem Epoxidharz, hydriertem Bisphenol Epoxidharz, hydriertem Polyphenol Epoxidharz, halogeniertem Bisphenol Epoxidharz, halogeniertem Polyphenol Epoxidharz, (cyclo)aliphatischem Epoxidharz und Mischungen daraus; und wobei
eine Glasübergangstemperatur des pulverförmigen Beschichtungsmaterials (104) mindestens 30 °C ist, gemessen mit Differenzial-Scanning-Kalorimetrie bei einer Erwärmungsrate von 20 K/min.

13. Das pulverförmige Beschichtungsmaterial (108) gemäß Anspruch 12, ferner aufweisend eines oder mehrere der folgenden:
das Epoxid-Äquivalentgewicht ist zwischen 200 g/eq und 800 fügt das ein, insbesondere zwischen 400 und 700 g/eq und ferner insbesondere zwischen 450 g/eq und 650 g/eq;
das Epoxidharz macht mindestens 1 Gew. %, insbesondere mindestens 10 Gew. %, insbesondere mindestens 30 Gew. %, insbesondere mindestens 50 Gew. %, und ferner insbesondere sogar mindestens 60 Gew. %, des Gesamtgewichts des pulverförmigen Beschichtungsmaterials (104) aus;
die Glasübergangstemperatur des pulverförmigen Beschichtungsmaterials (104) ist mindestens 40 °C, insbesondere mindestens 50 °C.

14. Verfahren zum Herstellen eines faserverstärkten Kunststoffes, wobei das Verfahren aufweist
Bereitstellen einer Mehrzahl von Fasern;
Aufbringen auf die Mehrzahl von Fasern eines pulverförmigen Beschichtungsmaterials gemäß einem beliebigen der Ansprüche 12 oder 13, wobei das pulverförmige Beschichtungsmaterial als ein Pulver aufgebracht wird, welches eine Mehrzahl von Pulverpartikeln hat.

15. Eine Verwendung eines pulverförmigen Beschichtungsmaterials (104) gemäß einem beliebigen der Ansprüche 12 oder 13 zum Herstellen eines faserverstärkten Kunststoffes.

## Revendications

1. Matériau de boîtier (108) pour un module photovoltaïque comprenant une pluralité de fibres et un matériau de revêtement en poudre (104),
**caractérisé en ce que** :
le matériau de revêtement en poudre (104) comprend une résine époxy avec un poids équivalent d'époxy compris entre 150 g/éq. et 1 800 g/éq ;
dans lequel la résine époxy est choisie parmi la résine époxy bisphénolique, la résine époxy polyphénolique, la résine époxy novolaque, la résine époxy phénolique, la résine époxy bisphénolique hydrogénée, la résine époxy polyphénolique hydrogénée, la résine époxy bisphénolique halogénée, la résine époxy polyphénolique halogénée, la résine époxy (cyclo)aliphatique et des mélanges de celles-ci ; et
dans lequel une température de transition vitreuse du matériau de revêtement en poudre non durci (104) est d'au moins 30°C, mesurée par calorimétrie à balayage différentiel à une vitesse de chauffage de 20 K/min.

2. Matériau de boîtier (108) selon la revendication 1, comprenant en outre un ou plusieurs des éléments suivants :
le poids équivalent d'époxy est compris entre 200 g/éq et 800 g/éq, en particulier entre 400 et 700 g/éq et en outre en particulier entre 450 g/éq. et 650 g/éq ;
la résine époxy représente au moins 1 % en poids, en particulier au moins 10 % en poids, en particulier au moins 30 % en poids, en particulier au moins 50 % en poids et encore plus en particulier au moins 60 % en poids du poids total du matériau de revêtement en poudre (104).

3. Matériau de boîtier (108) selon l'une quelconque des revendications précédentes, dans lequel une longueur d'écoulement de pastille du matériau de revêtement en poudre (104) est comprise entre 30 mm et 300 mm, en particulier entre 50 mm et 200 mm, en outre en particulier entre 80 mm et 160 mm et en outre en particulier entre 110 mm et 140 mm et dans lequel la longueur d'écoulement de pastille est déterminée par le procédé suivant comprenant les étapes consistant à :
(i) presser une quantité de 0,75 gramme du matériau de revêtement en poudre (104) en une pastille cylindrique d'un diamètre de 13 mm à une force de 20 kilo Newtons pendant au moins 5 secondes ;
(ii) placer la pastille de matériau de revêtement en poudre (104) sur une feuille de métal à température ambiante ;
(iii) mettre la feuille de métal avec la pastille dans un four préchauffé à la température d'imprégnation potentielle et tremper la pastille sur la feuille de métal dans une position horizontale pendant une demi-minute si la résine inclut un composant de résine acrylique et pendant une minute si la résine n'inclut pas de composant de résine acrylique ;
(iv) incliner la feuille de métal à un angle d'écoulement vers le bas de 65° et maintenir la feuille de métal dans cette position pendant 10 minutes à la température d'imprégnation potentielle ;
(v) retirer la feuille de métal à partir du four, refroidir la feuille de métal et le matériau de revêtement en poudre (104) dans une position horizontale, mesurer une longueur maximale de pastille sur la feuille de métal et prendre cette longueur maximale en tant que longueur d'écoulement de pilule.

4. Matériau de boîtier (108) selon l'une quelconque des revendications précédentes, dans lequel
une viscosité du matériau de revêtement en poudre non durci (104) à 140°C est inférieure à 20 000 pascals secondes, en particulier inférieure à 10 000 pascals secondes, en particulier inférieure à 7 000 pascals secondes, en particulier inférieure à 5 000 pascals secondes et en outre en particulier inférieure à 4 000 pascals secondes et encore plus en particulier inférieure à 3 000 pascals secondes ;
et/ou
dans lequel le matériau de revêtement en poudre (104) présente une viscosité minimale, lorsqu'il est chauffé à partir de la température ambiante à une vitesse de chauffage de 5 Kelvins par minute jusqu'à au moins 180°C et/ou à une température à laquelle le durcissement du matériau de revêtement en poudre survient, dans lequel la viscosité minimale est dans une plage allant de 3 pascals secondes à 20 000 pascals secondes, en particulier dans une plage allant de 4 pascals secondes à 10 000 pascals secondes et en outre en particulier dans une plage allant de 5 pascals secondes à 7 000 pascals secondes ;
et/ou
dans lequel un temps de gel du matériau de revêtement en poudre se situe dans une plage allant de 20 secondes à 400 secondes, de préférence de 40 secondes à 200 secondes et plus préférablement de 50 secondes à 100 secondes à 180°C lorsqu'il est mesuré selon la norme ONORM EN ISO 8130-6.

5. Matériau de boîtier (108) selon l'une quelconque des revendications précédentes, dans lequel le matériau de revêtement en poudre (104) comprend en outre une résine de polyester, dans lequel une température de transition vitreuse de la résine de polyester est d'au moins 30°C, en particulier d'au moins 40°C et en outre en particulier d'au moins 50°C, et dans lequel la résine de polyester est de préférence amorphe.

6. Matériau de boîtier (108) selon la revendication 5, dans lequel la résine de polyester comprend des groupes hydroxyle et/ou des groupes carboxyle ;
en particulier dans lequel un indice d'hydroxyle de la résine de polyester est compris entre 10 et 300 mg de KOH/g et/ou l'indice de carboxyle de la résine de polyester est compris entre 5 et 100 mg de KOH/g ;
et/ou
en particulier dans lequel la résine de polyester représente 1 à 80 % en poids, en particulier 3 à 60 % en poids, en particulier 5 à 50 % en poids et encore plus en particulier 7 à 40 % en poids du poids total du matériau de revêtement en poudre (104).

7. Matériau de boîtier (108) selon l'une quelconque des revendications précédentes
dans lequel le matériau de revêtement en poudre (104) comprend jusqu'à 50 % en poids, en particulier jusqu'à 30 % en poids, en outre en particulier jusqu'à 15 % en poids, et en outre en particulier jusqu'à 10 % en poids d'un composant diminuant la viscosité par rapport au poids total du matériau de revêtement en poudre (104) ; et
en particulier dans lequel le composant diminuant la viscosité est choisi parmi un composant liant (semi)cristallin, une huile, en particulier de l'huile de ricin ou un dérivé de celle-ci, du polyéthylène (PE), en particulier du PE à faible densité linéaire (LLD), du polytétrahydorfurane (poly-THF), des élastomères thermoplastiques, en particulier du polyuréthane thermoplastique (TPU), du polypropylène, en particulier du polypropylène atactique, et des mélanges et/ou des dérivés de ceux-ci.

8. Matériau de boîtier (108) selon l'une quelconque des revendications précédentes, dans lequel le matériau de revêtement en poudre comprend au moins un composant parmi un composant liant (semi)cristallin et au moins un agent de durcissement ;
en particulier dans lequel le composant liant (semi)cristallin comprend une résine époxy et/ou polyester ;
en outre, en particulier, dans lequel le au moins un agent de durcissement présente un point de ramollissement à une température de 150°C ou moins.

9. Matériau de logement (108) selon la revendication 8, dans lequel le au moins un agent de durcissement est choisi dans le groupe constitué d'isocyanate, d'isocyanate bloqué, d'iscocyanate latent, d'urétdione, d'amines, d'époxydes, d'acides carboxyliques et d'anhydrides, d'hydroxylalkylamides (appelés PRIMIDs), de TGIC, d'acrylates de glycidyle et de mélanges de deux ou plus de ces composants.

10. Matériau de boîtier (108) selon l'une quelconque des revendications 1 à 9, dans lequel le matériau de revêtement en poudre (104) comprend au moins un pigment, en particulier un pigment de couleur.

11. Module photovoltaïque (112) comprenant un matériau de boîtier (108) selon l'une quelconque des revendications précédentes.

12. Matériau de revêtement en poudre (104) pour imprégner une pluralité de fibres, **caractérisé en ce qu'**il comprend
une résine époxy avec un poids équivalent d'époxy compris entre 150 g/éq et 1800 g/éq ; dans lequel
la résine époxy est choisie parmi la résine époxy bisphénolique, la résine époxy polyphénolique, la résine époxy novolaque, la résine époxy phénolique, la résine époxy bisphénolique hydrogénée, la résine époxy polyphénolique hydrogénée, la résine époxy bisphénolique halogénée, la résine époxy polyphénolique halogénée, la résine époxy (cyclo)aliphatique et des mélanges de celles-ci ; et dans lequel
une température de transition vitreuse du matériau de revêtement en poudre (104) est d'au moins 30°C, mesurée par calorimétrie à balayage différentiel à une vitesse de chauffage de 20 K/min.

13. Matériau de revêtement en poudre (108) selon la revendication 12, comprenant en outre un ou plusieurs des éléments suivants :
le poids équivalent d'époxy est compris entre 200 g/éq et 800 g/éq, en particulier entre 400 et 700 g/éq, et en outre en particulier entre 450 g/éq et 650 g/éq ; la résine d'époxy représente au moins 1 % en poids, en particulier au moins 10 % en poids, en particulier au moins 30 % en poids, en particulier au moins 50 % en poids et en outre en particulier au moins 60 % en poids du poids total du matériau de revêtement en poudre (104) ;
la température de transition vitreuse du matériau de revêtement en poudre (104) est d'au moins 40°C, en particulier d'au moins 50°C.

14. Procédé de fabrication d'une matière plastique renforcée par des fibres, le procédé comprenant les étapes consistant à :
fournir une pluralité de fibres ;
appliquer à la pluralité de fibres un matériau de revêtement en poudre selon l'une quelconque des revendications 12 ou 13, dans lequel le matériau de revêtement en poudre est appliqué sous la forme d'une poudre ayant une pluralité de particules de poudre.

15. Utilisation d'un matériau de revêtement en poudre (104) selon l'une quelconque des revendications 12 ou 13 pour fabriquer une matière plastique renforcée de fibres.
